# EUROPEAN PATENT APPLICATION

(11) **EP 2 677 005 A1**
(43) Date of publication of application: **25.12.2013**
(21) Application number: 13172705.9
(22) Date of filing: 19.06.2013
(51) Int. Cl.: C08L 83/04, G02B 1/04, C08G 77/16, C08G 77/20, C08K 3/10, C08K 5/10

(54) **Silicone resin composition, semi-cured material sheet, producing method of silicone cured material, light emitting diode device, and producing method thereof**

(30) Priority: 21.06.2012 JP 2012140060
(71) Applicant: NITTO DENKO CORPORATION, Ibaraki-shi, Osaka 567-8680 (JP)
(72) Inventor: Ona, Haruka, Osaka, 567-8680 (JP); Katayama, Hiroyuki, Osaka, 567-8680 (JP); Nakanishi, Sadahiro, Osaka, 567-8680 (JP)
(74) Representative: HOFFMANN EITLE

(57) **Abstract**

A silicone resin composition contains a polysiloxane containing at least one pair of condensable substituted groups capable of condensation by heating and at least one pair of addable substituted groups capable of addition by an active energy ray.

## Description

### BACKGROUND OF THE INVENTION

### Field of the Invention

The present invention relates to a silicone resin composition, a semi-cured material sheet, a producing method of a silicone cured material, a light emitting diode device, and a producing method thereof, to be specific, to a producing method of a light emitting diode device, a producing method of a silicone cured material used in the light emitting 0 diode device, a semi-cured material sheet used in the silicone cured material, a silicone resin composition, and a light emitting diode device obtained by the producing method of a light emitting diode device.

### Description of Related Art

A light emitting diode device, conventionally, has a low electric power consumption and a long life, and is used for various optical uses. The light emitting diode device includes a light emitting diode element and the light emitting diode element is encapsulated by an encapsulating layer (an encapsulating material) that is made of a cured material of a silicone resin composition (a silicone cured material).

For example, an encapsulating material for an optical semiconductor device containing a first organopolysiloxane (excluding an organopolysiloxane having a hydrogen atom bonded to a silicon atom) having an alkenyl group bonded to a silicon atom and an aryl group bonded to a silicon atom and a second organopolysiloxane having a hydrogen atom bonded to a silicon atom and an aryl group bonded to a silicon atom has been proposed (ref: for example, the following Japanese Unexamined Patent Publication No. 2012-007136).

In Japanese Unexamined Patent Publication No. 2012-007136, it is proposed that a cured material that encapsulates a light emitting element is formed by a step-curing method in which the encapsulating material for an optical semiconductor device is poured into a housing material surrounding the light emitting element to be then once semi-cured (brought into a B-stage state) at a low temperature to be thereafter cured (brought into a C-stage state) at a high temperature.

### SUMMARY OF THE INVENTION

In the step-curing method proposed in Japanese Unexamined Patent Publication No. 2012-007136, however, there is a disadvantage that a duration required for bringing the encapsulating material for an optical semiconductor device in a B-stage state into a C-stage state is long, so that the production efficiency of the light emitting diode device is reduced.

It is an object of the present invention to provide a method for producing a light emitting diode device having excellent production efficiency, a method for producing a silicone cured material used in the light emitting diode device and capable of shortening a duration required for curing, a semi-cured material sheet used in the silicone cured material, a silicone resin composition, and a light emitting diode device obtained by the method for producing a light emitting diode device.

A silicone resin composition of the present invention contains a polysiloxane containing at least one pair of codensable substituted groups capable of condensation by heating and at least one pair of addable substituted groups capable of addition by an active energy ray.

A silicone resin composition of the present invention contains a first polysiloxane containing at least one pair of condensable substituted groups capable of condensation by heating and at least one addable substituted group capable of addition by an active energy ray and a second polysiloxane containing at least one addable substituted group capable of addition by an active energy ray and making one pair with the addable substituted group in the first polysiloxane.

In the silicone resin composition of the present invention, it is preferable that the one pair of addable substituted groups is at least one combination selected from the group consisting of combination of a hydrosilyl group and an ethylenically unsaturated group-containing group; combination of (meth)acryloyl group-containing groups with themselves; combination of epoxy group-containing groups with themselves; and combination of a thiol group and an ethylenically unsaturated group-containing group.

In the silicone resin composition of the present invention, it is preferable that the one pair of condensable substituted group is at least one combination selected from the group consisting of combination of at least one substituted group selected from the group consisting of a hydroxyl group, an alkoxy group, an acyloxy group, an amino group, an alkylamino group, an alkenyloxy group, and a halogen atom and a hydroxyl group and combination of at least one substituted group selected from a hydroxyl group and an alkoxy group and a hydrogen atom.

In the silicone resin composition of the present invention, it is preferable that the silicone resin composition further contains an addition catalyst and the addition catalyst is a platinum cyclopentadienyl complex.

A semi-cured material sheet of the present invention is obtained by applying and heating the above-described silicone resin composition, wherein the silicone resin composition contains a polysiloxane containing at least one pair of condensable substituted groups capable of condensation by heating and at least one pair of addable substituted groups capable of addition by an active energy ray.

A method for producing a silicone cured material of the present invention includes the steps of heating the above-described silicone resin composition to obtain a silicone semi-cured material and applying an active energy ray to the silicone semi-cured material to be cured, wherein the silicone resin composition contains a polysiloxane containing at least one pair of condensable substituted groups capable of condensation by heating and at least one pair of addable substituted groups capable of addition by an active energy ray.

In the method for producing a silicone cured material of the present invention, it is preferable that in the step of curing the silicone semi-cured material, the silicone semi-cured material is further heated.

In the method for producing a silicone cured material of the present invention, it is preferable that in the step of obtaining the silicone semi-cured material, the silicone resin composition is heated at 40 to 180°C for 0.1 to 180 minutes.

A method for producing a light emitting diode device of the present invention includes a step of heating the above-described silicone resin composition to obtain a silicone semi-cured material, a covering step of covering a light emitting diode element with the silicone resin composition or the silicone semi-cured material, and an encapsulating step of encapsulating the light emitting diode element by an encapsulating layer made of a silicone cured material formed by applying an active energy ray to the silicone semi-cured material to be cured, wherein the silicone resin composition contains a polysiloxane containing at least one pair of condensable substituted groups capable of condensation by heating and at least one pair of addable substituted groups capable of addition by an active energy ray.

In the method for producing a light emitting diode device of the present invention, it is preferable that a mounting step in which the light emitting diode element is mounted on a board is further included and the covering step is performed after the mounting step.

In the method for producing a light emitting diode device of the present invention, it is preferable that a mounting step in which the light emitting diode element is mounted on a board is further included and the mounting step is performed after the encapsulating step.

A method for producing a light emitting diode device of the present invention includes an embedding step of embedding a light emitting diode element by the above-described semi-cured material sheet and an encapsulating step of encapsulating the light emitting diode element by an encapsulating layer made of a silicone cured material formed by applying an active energy ray to the semi-cured material sheet to be cured, wherein the semi-cured material sheet is obtained by applying and heating a silicone resin composition, and the silicone resin composition contains a polysiloxane containing at least one pair of condensable substituted groups capable of condensation by heating and at least one pair of addable substituted groups capable of addition by an active energy ray.

In the method for producing a light emitting diode device of the present invention, it is preferable that a mounting step in which the light emitting diode element is mounted on a board is further included and the embedding step is performed after the mounting step.

In the method for producing a light emitting diode device of the present invention, it is preferable that a mounting step in which the light emitting diode element is mounted on a board is further included and the mounting step is performed after the encapsulating step.

A light emitting diode device of the present invention is obtained by a method for producing a light emitting diode device including a step of heating a silicone resin composition to obtain a silicone semi-cured material, a covering step of covering a light emitting diode element with the silicone resin composition or the silicone semi-cured material, and an encapsulating step of encapsulating the light emitting diode element by an encapsulating layer made of a silicone cured material formed by applying an active energy ray to the silicone semi-cured material to be cured, wherein the silicone resin composition contains a polysiloxane containing at least one pair of condensable substituted groups capable of condensation by heating and at least one pair of addable substituted groups capable of addition by an active energy ray.

In the method for producing a silicone cured material of the present invention, the silicone resin composition of the present invention is heated to obtain the silicone semi-cured material and thereafter, the active energy ray is applied to the silicone semi-cured material to be cured, so that a duration required for curing of the silicone semi-cured material can be shortened.

Thus, in the method for producing a light emitting diode device of the present invention, the production efficiency of the light emitting diode device of the present invention is excellent.

According to the method for producing a light emitting diode device of the present invention, the light emitting diode element is embedded by the semi-cured material sheet of the present invention obtained by heating the silicone resin composition of the present invention and thereafter, the active energy ray is applied to the silicone semi-cured material to be cured. Thus, while the light emitting diode element is embedded by an easy method, the encapsulating layer made of the silicone cured material is easily formed and a duration required for the step of encapsulating the light emitting diode element by the encapsulating layer can be shortened, so that the production efficiency of the light emitting diode device is excellent.

### BRIEF DESCRIPTION OF THE DRAWINGS

FIG. 1 shows process drawings for preparing an encapsulating sheet that is one embodiment of a semi-cured material sheet of the present invention:
   FIG. 1 (a) illustrating a step of preparing a release sheet and
   FIG. 1 (b) illustrating a step of forming the encapsulating sheet.
FIG. 2 shows process drawings for illustrating one embodiment of a method for producing a light emitting diode device of the present invention:
   FIG. 2 (a) illustrating a step of disposing an encapsulating sheet in opposed relation to a board,
   FIG. 2 (b) illustrating a step of embedding a light emitting diode element by the encapsulating sheet, and
   FIG. 2 (c) illustrating a step of encapsulating the light emitting diode element by an encapsulating layer made of a silicone cured material by applying an ultraviolet ray to the encapsulating sheet.
FIG. 3 shows process drawings for illustrating another embodiment of a method for producing a light emitting diode device of the present invention:
   FIG. 3 (a) illustrating a step of preparing a board provided with a reflector,
   FIG. 3 (b) illustrating a step of potting a silicone resin composition into the reflector to be subsequently semi-cured by heating, and
   FIG. 3 (c) illustrating a step of encapsulating a light emitting diode element by an encapsulating layer made of a silicone cured material by applying an ultraviolet ray to a semi-cured layer.
FIG. 4 shows process drawings for illustrating another embodiment of a method for producing a light emitting diode device of the present invention:
   FIG. 4 (a) illustrating a step of preparing a light emitting diode element supported by a support,
   FIG. 4 (b) illustrating a step of embedding the light emitting diode element by an encapsulating sheet, and
   FIG. 4 (c) illustrating a step of encapsulating the light emitting diode element by an encapsulating layer made of a silicone cured material by applying an ultraviolet ray to the encapsulating sheet.
FIG. 5 shows process drawings for illustrating another embodiment of a method for producing a light emitting diode device of the present invention, subsequent to FIG. 4:
   FIG. 5 (d) illustrating a step of peeling the encapsulating layer and the light emitting diode element from the support,
   FIG. 5 (e) illustrating a step of disposing the encapsulating layer and the light emitting diode element in opposed relation to a board, and
   FIG. 5 (f) illustrating a step of mounting the light emitting diode element on the board.

### DETAILED DESCRIPTION OF THE INVENTION

A silicone resin composition of the present invention contains a first silicone resin composition and a second silicone resin composition.

In the following, the first silicone resin composition and the second silicone resin composition are described in detail.

<First Silicone Resin Composition>

The first silicone resin composition contains a first polysiloxane containing at least one pair of condensable substituted groups that is capable of condensation by heating and at least one addable substituted group that is capable of addition by an active energy ray and a second polysiloxane containing at least one addable substituted group that is capable of addition by an active energy ray and makes one pair with the addable substituted group in the first polysiloxane.

An example of the one pair of condensable substituted groups includes combination (a first combination group) of at least one substituted group selected from the group consisting of a hydroxyl group (-OH), an alkoxy group, an acyloxy group, an amino group (-NH₂), an alkylamino group, an alkenyloxy group, and a halogen atom and a hydroxyl group.

The alkoxy group is represented by -OR¹. R¹ represents an alkyl group or a cycloalkyl group. An example of the alkyl group includes a straight chain or branched chain alkyl group having 1 to 20 carbon atoms such as a methyl group, an ethyl group, a propyl group, an isopropyl group, a butyl group, an isobutyl group, a pentyl group, and a hexyl group. Preferably, an alkyl group having 1 to 10 carbon atoms is used, or more preferably, an alkyl group having 1 to 6 carbon atoms is used. An example of the cycloalkyl group includes a cycloalkyl group having 3 to 6 carbon atoms such as a cyclopentyl group and a cyclohexyl group.

An example of the alkoxy group includes an alkoxy group containing a straight chain or branched chain alkyl group having 1 to 20 carbon atoms such as a methoxy group, an ethoxy group, a propoxy group, an isopropoxy group, a butoxy group, an isobutoxy group, a pentyloxy group, and a hexyloxy group.

An example of the alkoxy group also includes an alkoxy group containing a cycloalkyl group having 3 to 6 carbon atoms such as a cyclopentyloxy group and a cyclohexyloxy group.

As the alkoxy group, preferably, in view of easy preparation and thermal stability, an alkoxy group containing an alkyl group having 1 to 10 carbon atoms is used, more preferably, an alkoxy group containing an alkyl group having 1 to 6 carbon atoms is used, or more preferably, a methoxy group is used.

The acyloxy group is represented by -OCOR¹. R¹ represents the above-described alkyl group or cycloalkyl group. Preferably, as R¹, an alkyl group is used.

Examples of the acyloxy group include an acetoxy group (-OCOCH₃), -OCOC₂H₅, and -OCOC₃H₇. Preferably, an acetoxy group is used.

Examples of the alkylamino group include a monoalkylamino group and a dialkylamino group.

The monoalkylamino group is represented by -NR²H. R² represents an alkyl group or a cycloalkyl group. Preferably, as R², an alkyl group is used. An example of the monoalkylamino group includes a monoalkylamino group having 1 to 10 carbon atoms of an N-substituted alkyl group such as a methylamino group, an ethylamino group, an n-propylamino group, and an isopropylamino group.

The dialkylamino group is represented by -NR². R² represents alkyl groups or cycloalkyl groups that may be the same or different from each other. R² is the same as that described above. An example of the dialkylamino group includes a dialkylamino group having 1 to 10 carbon atoms of an N,N-substituted alkyl such as a dimethylamino group, a diethylamino group, a di-n-propylamino group, a diisopropylamino group, an ethylmethylamino group, a methyl-n-propylamino group, and a methylisopropylamino group.

As the alkylamino group, preferably, a dialkylamino group is used, more preferably, a dialkylamino group having the same number of carbon atoms of N,N-substituted alkyl is used, or further more preferably, a dimethylamino group is used.

The alkenyloxy group is represented by -OCOR³. R³ represents an alkenyl group or a cycloalkenyl group. An example of the alkenyl group includes an alkenyl group having 3 to 10 carbon atoms such as a vinyl group, an allyl group, a propenyl group, an isopropenyl group, a butenyl group, a pentenyl group, a hexenyl group, a heptenyl group, and an octenyl group. An example of the cycloalkenyl group includes a cycloalkenyl group having 3 to 10 carbon atoms such as a cyclohexenyl group, a cyclooctenyl group, and a norbornenyl group.

As the alkenyloxy group, preferably, an alkenyloxy group containing an alkenyl group having 2 to 10 carbon atoms is used, or more preferably, an isopropenyloxy group is used.

Examples of the halogen atom include a fluorine atom, a chlorine atom, a bromine atom, and an iodine atom. Preferably, a chlorine atom is used.

To be specific, an example of the first combination group includes one pair of combinations such as combination of hydroxyl groups with themselves, combination of an alkoxy group and a hydroxyl group, combination of an acyloxy group and a hydroxyl group, combination of an amino group and a hydroxyl group, combination of an alkylamino group and a hydroxyl group, combination of an alkenyloxy group and a hydroxyl group, and combination of a halogen atom and a hydroxyl group.

Furthermore, an example of the first combination group also includes two pairs (to be specific, the total of two pairs of one pair of an alkoxy group and a hydroxyl group and the other pair of an acyloxy group and a hydroxyl group) or more of combinations such as combination of an alkoxy group, an acyloxy group, and a hydroxyl group.

As the first combination group, preferably, combination of hydroxyl groups with themselves and combination of an alkoxy group and a hydroxyl group are used, more preferably, combination of an alkoxy group and a hydroxyl group is used, further more preferably, combination of an alkoxy group containing an alkyl group having 1 to 10 carbon atoms and a hydroxyl group is used, or particularly preferably, combination of a methoxy group and a hydroxyl group is used.

In the one pair of condensable substituted groups made of the first combination group, two silicon atoms are bonded to each other via an oxide atom by condensation represented by the following formula (1), that is, silanol condensation. 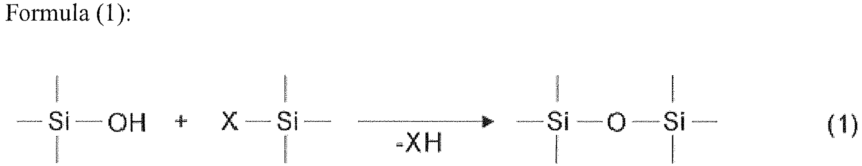 X= -OH, -OR¹,-OCOR¹,-NH₂,-NR²H,-NR²₂,-OCOR³, halogen atom
(where, in formula, R¹ to R³ are the same as those described above.)

An example of the one pair of condensable substituted groups includes combination (a second combination group) of at least one substituted group selected from a hydroxyl group and an alkoxy group and a hydrogen atom.

An example of the alkoxy group includes the alkoxy group illustrated in the first combination group.

To be specific, an example of the second combination group includes one pair of combinations such as combination of a hydroxyl group and a hydrogen atom and combination of an alkoxy group and a hydrogen atom.

Furthermore, an example of the second combination group also includes two pairs (to be specific, the total of two pairs of one pair of a hydroxyl group and a hydrogen atom and the other pair of an alkoxy group and a hydrogen atom) or more of combinations such as combination of a hydroxyl group, an alkoxy group, and a hydrogen atom.

In one pair of condensable substituted groups made of the second combination group, two silicon atoms are bonded to each other via an oxide atom by condensation represented by the following formula (2), that is, hydrosilane condensation.

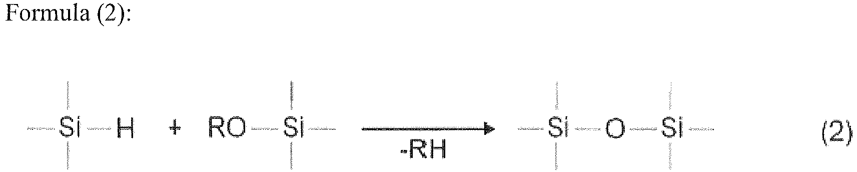

OR= OH, -OR¹

(where, in formula, R¹ is the same as that described above.)

The above-described first combination groups and second combination groups can be contained in the first polysiloxane alone or in combination of a plurality of groups.

Each of the condensable substituted groups is bonded to a silicon atom that is at the end of the main chain, which constitutes a molecule in the first polysiloxane; in the middle of the main chain; and/or in a side chain that branches off from the main chain. Preferably, one condensable substituted group (preferably, a hydroxyl group) is bonded to the silicon atoms at both ends of the main chain and the other condensable substituted group (preferably, an alkoxy group) is bonded to the silicon atom in the middle of the main chain (ref: Formula (16) to be described later).

In one pair of addable substituted groups, at least one piece of one addable substituted group is contained in the first polysiloxane and at least one piece of the other addable substituted group is contained in the second polysiloxane.

Examples of the one pair of addable substituted groups include combination of a hydrosilyl group and an ethylenically unsaturated group-containing group, combination of (meth)acryloyl group-containing groups with themselves, combination of epoxy group-containing groups with themselves, and combination of a thiol group-containing group and an ethylenically unsaturated group-containing group.

The hydrosilyl group is represented by -SiH and is a group in which a hydrogen atom is directly bonded to a silicon atom.

The ethylenically unsaturated group-containing group contains, in a molecule, an ethylenically unsaturated group. Examples of the ethylenically unsaturated group-containing group include the above-described alkenyl group and cycloalkenyl group. Preferably, an alkenyl group is used, or more preferably, a vinyl group is used.

The (meth)acryloyl group-containing group contains, in a molecule, a methacryloyl group (CH₂=C(CH₃)COO-) and/or an acryloyl group (CH₂=CHCOO-) and to be specific, is represented by the following formula (3).
Formula (3):

CH₂ = CYCOO - R⁴- (3)

(where, in formula, Y represents a hydrogen atom or a methyl group and R⁴ represents a divalent hydrocarbon group selected from a saturated hydrocarbon group and an aromatic hydrocarbon group.)

Examples of the divalent saturated hydrocarbon group include an alkylene group having 1 to 6 carbon atoms such as a methylene group, an ethylene group, a propylene group, and a butylene group and a cycloalkylene group having 3 to 8 carbon atoms such as a cyclopentylene group and a cyclohexylene group.

An example of the divalent aromatic hydrocarbon group includes an arylene group having 6 to 10 carbon atoms such as a phenylene group and a naphthylene group.

As the divalent hydrocarbon group, preferably, a divalent saturated hydrocarbon group is used, more preferably, an alkylene group is used, or further more preferably, a propylene group is used.

To be specific, an example of the (meth)acryloyl group-containing group includes a 3-(meth)acryloxypropyl group.

The epoxy group-containing group contains, in a molecule, an epoxy group. Examples of the epoxy group-containing group include an epoxy group, a glycidyl ether group, and an epoxy cycloalkyl group. Preferably, a glycidyl ether group and an epoxy cycloalkyl group are used.

The glycidyl ether group is a glycidoxy alkyl group, for example, represented by formula (4). 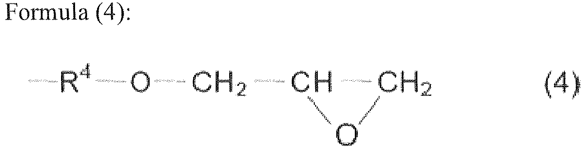 (where, in formula (4), R⁴ represents a divalent hydrocarbon group selected from a saturated hydrocarbon group and an aromatic hydrocarbon group.)

The divalent hydrocarbon group represented by R⁴ is the same as the divalent hydrocarbon group in the above-described formula (3).

An example of the glycidyl ether group includes a 3-glycidoxypropyl group.

An example of the epoxy cycloalkyl group includes an epoxy cyclohexyl group represented by the following formula (5). 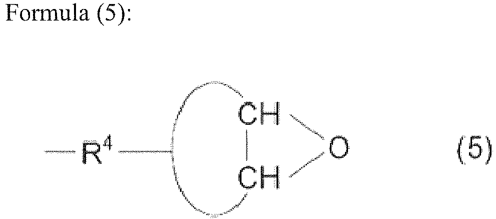 (where, in formula, R⁴ represents a divalent hydrocarbon group selected from a saturated hydrocarbon group and an aromatic hydrocarbon group.)

An example of the divalent saturated hydrocarbon group includes the divalent hydrocarbon group in the above-described formula (3). Preferably, the above-described alkylene group having 1 to 6 carbon atoms is used, or more preferably, an ethylene group is used.

To be specific, an example of the epoxy cycloalkyl group includes a 2-(3,4-epoxy cyclohexyl)ethyl group.

The thiol group-containing group contains, in a molecule, a thiol group (-SH). Examples thereof include a thiol group and a mercaptoalkyl group such as mercaptomethyl, mercaptoethyl, and mercaptopropyl.

One addable substituted group is replaced with the end and the middle of the main chain and/or a side chain in the first polysiloxane. The other addable substituted group is replaced with or positioned at the end and the middle of the main chain and/or a side chain in the second polysiloxane.

An example of the addable substituted group includes one pair or two or more pairs of combinations described above.

As one pair of addable substituted groups, in view of heat resistance and transparency, preferably, combination of a hydrosilyl group and an alkenyl group is used.

As shown in the following formulas (6) to (9), one pair of addable substituted groups is subjected to addition. 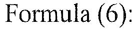 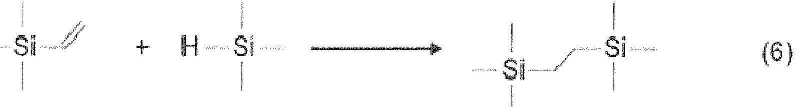 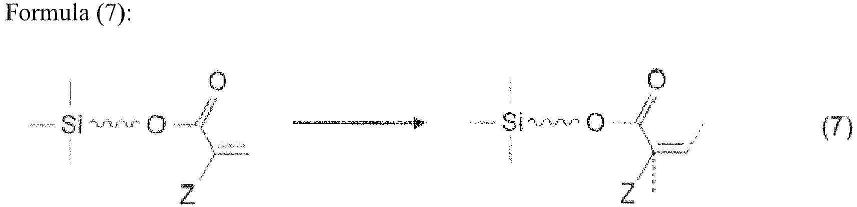 (where, in formula, Z represents a hydrogen atom or a methyl group.)

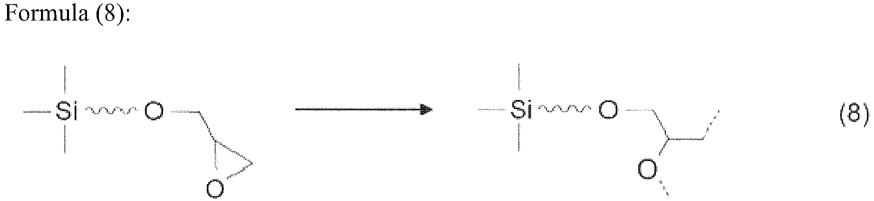

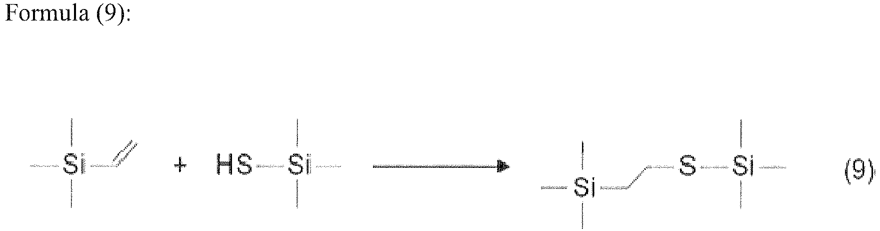

To be specific, when one pair of addable substituted groups is combination of a hydrosilyl group and an alkenyl group (to be specific, a vinyl group), as shown by the above-described formula (6), hydrosilylation (hydrosilylation addition) is performed.

When one pair of addable substituted groups is combination of (meth)acryloyl groups with themselves, as shown by the above-described formula (7), polymerization (addition polymerization) is performed.

When one pair of addable substituted groups is combination of glycidyl ether groups with themselves, as shown by the above-described formula (8), ring-opening addition is performed based on ring opening of an epoxy group.

When one pair of addable substituted groups is combination of a thiol group and an alkenyl group (to be specific, a vinyl group), as shown by the above-described formula (9), a thiol-ene reaction (addition) is performed.

To be specific, the first polysiloxane is represented by the following formula (10).

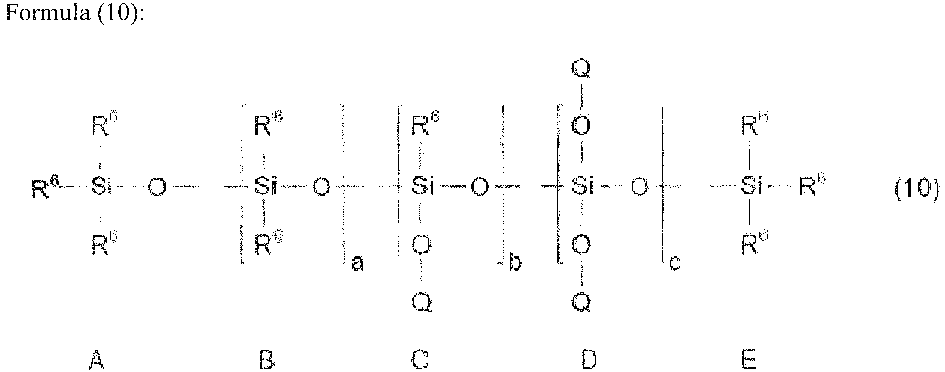

(where, in formula, R⁶ represents a monovalent hydrocarbon group selected from a saturated hydrocarbon group and an aromatic hydrocarbon group; a condensable substituted group; and/or an addable substituted group. SiR⁶ may represent an addable substituted group. A to E represent a constituent unit, A and E represent an end unit, and B to D represent a repeating unit. Q represents a constituent unit of B to E. "a" + "b" + "c" is an integer of 1 or more. Of a plurality of R⁶s, at least one pair of R⁶s represents a condensable substituted group, and at least one R⁶ or at least one SiR⁶ represents an addable substituted group.)

In formula (10), of the monovalent hydrocarbon groups represented by R⁶, examples of the monovalent saturated hydrocarbon group include an alkyl group and a cycloalkyl group. Examples of the alkyl group and the cycloalkyl group include the same alkyl group and cycloalkyl group as those illustrated in the above-described R¹, respectively.

In formula (10), of the monovalent hydrocarbon groups represented by R⁶, an example of the monovalent aromatic hydrocarbon group includes an aryl group having 6 to 10 carbon atoms such as a phenyl group and a naphthyl group.

As the monovalent hydrocarbon group, preferably, methyl and phenyl are used.

"a" is, for example, an integer of 0 to 100000, preferably an integer of 1 to 10000, or more preferably an integer of 2 to 10000.

"b" is, for example, an integer of 0 to 100000, or preferably an integer of 0 to 10000.

"c" is, for example, an integer of 0 to 100000, or preferably an integer of 0 to 10000.

"a" + "b" + "c" is preferably an integer of 1 to 100000, or more preferably an integer of 1 to 10000. That is, of "a" to "c", at least one is an integer of 1 or more.

Examples of the condensable substituted group represented by R⁶ and the addable substituted group represented by R⁶ or SiR⁶ include the above-described condensable substituted group and addable substituted group, respectively.

The first polysiloxane is, for example, prepared by allowing a first silicon compound containing both at least one condensable substituted group and at least one addable substituted group, and a second silicon compound containing at least one condensable substituted group to be partially subjected to condensation (ref: formula (16) to be described later).

The first silicon compound is, for example, represented by the following formula (11). Formula (11):

R⁷SiBₙX¹₃-ₙ (11)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group. "n" represents 0 or 1.)

As the addable substituted group represented by R⁷ or SiR⁷, for example, the above-described addable substituted group is used; preferably, one of the substituted groups constituting one pair of addable substituted groups is used; more preferably, an ethylenicaly unsaturated group-containing group, a (meth)acryloyl group-containing group, and an epoxy group-containing group are used; further more preferably, an ethylenically unsaturated group-containing group is used; particularly preferably, an alkenyl group is used; or most preferably, a vinyl group is used.

As the condensable substituted group represented by X¹, for example, the above-described condensable substituted group is used; preferably, one of the substituted groups constituting one pair of condensable substituted groups is used; more preferably, a hydroxyl group, an alkoxy group, an acyloxy group, an amino group, an alkylamino group, an alkenyloxy group, and a halogen atom are used; or further more preferably, an alkoxy group is used.

As the alkoxy group represented by X¹, for example, in view of reactivity, preferably, an alkoxy group containing an alkyl group having 1 to 10 carbon atoms is used, or more preferably, an alkoxy group containing an alkyl group having 1 to 6 carbon atoms is used. To be specific, a methoxy group is used.

The monovalent hydrocarbon group represented by B is the same monovalent hydrocarbon group as that illustrated by R⁶ in formula (10).

When "n" is 0, the first silicon compound is represented by the following formula (12) and is defined as a trifunctional silicon compound containing three condensable substituted groups.
Formula (12):

R⁷SiX¹₃ (12)

(where, in formula, R⁷ or SiR⁷ represents an addable substituted group and X¹ represents a condensable substituted group.)

Examples of the trifunctional silicon compound include a vinyltrimethoxysilane, a vinyltriethoxysilane, an allyltrimethoxysilane, a propenyltrimethoxysilane, a norbornenyltrimethoxysilane, an octenyltrimethoxysilane, a 3-acryloxypropyltrimethoxysilane, a 3-methacryloxypropyltriethoxysilane, 3-methacryloxypropyltrimethoxysilane, a 3-glycidoxypropyltriethoxysilane, a 3-glycidoxypropyltrimethoxysilane, and 2-(3,4-epoxycyclohexyl)ethyltrimethoxysilane.

These trifunctional silicon compounds can be used alone or in combination of two or more.

As the trifunctional silicon compound, preferably, a vinyltrimethoxysilane in which R⁷ is a vinyl group and all of the X¹s are methoxy groups in the above-described formula (12) is used.

On the other hand, in the above-described formula (11), when "n" is 1, the first silicon compound is represented by the following formula (13) and is defined as a bifunctional silicon compound containing two condensable substituted groups.
Formula (13):

R⁷SiBX¹₂ (13)

(where, in formula, R⁷ or SiR⁷ represents an addable substituted group; B represents a monovalent hydrocarbon group selected from a saturated hydrocarbon group and an aromatic hydrocarbon group; and X¹ represents a condensable substituted group.)

R⁷, SiR⁷, B, and X¹ are the same as those described above.

Examples of the bifunctional silicon compound include a vinyldimethoxymethylsilane, a vinyldiethoxymethylsilane, an allyldimethoxymethylsilane, a propenyldimethoxymethylsilane, a norbornenyldimethoxymethylsilane, an octenyldimethoxymethylsilane, an octenyldiethoxymethylsilane, a 3-acryloxypropyldimethoxymethylsilane, a 3-methacryloxypropyldimethoxymethylsilane, a 3-methacryloxypropyldimethoxymethylsilane, a 3-glycidoxypropyldiethoxynethylsilane, a 3-glycidoxypropyldimethoxymethylsilane, and a 2-(3,4-epoxycyclohexyl)ethyldimethoxymethylsilane.

These bifunctional silicon compounds can be used alone or in combination of two or more.

As the bifunctional silicon compound, preferably, a vinyldimethoxymethylsilane in which R⁷ is a vinyl group, B is a methyl group, and all of the X¹s are methoxy groups in the above-described formula (13) is used.

A commercially available product can be used as the first silicon compound and a first silicon compound synthesized in accordance with a known method can be also used.

These first silicon compounds can be used alone or in combination of two or more.

To be specific, a trifunctional silicon compound is used alone, a bifunctional silicon compound is used alone, or a trifunctional silicon compound and a bifunctional silicon compound are used in combination. Preferably, a trifunctional silicon compound is used alone, and a trifunctional silicon compound and a bifunctional silicon compound are used in combination.

An example of the second silicon compound includes a polysiloxane containing at least two condensable substituted groups, to be specific, containing a condensable substituted group bonded to a silicon atom at the end of the main chain and/or a condensable substituted group bonded to a silicon atom in a side chain that branches off from the main chain.

Preferably, the second silicon compound contains a condensable substituted group bonded to the silicon atoms at both ends of the main chain (a bifunctional silicon compound).

The second silicon compound is a dual-end type polysiloxane (a bifunctional polysiloxane) represented by the following formula (14). 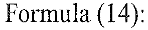 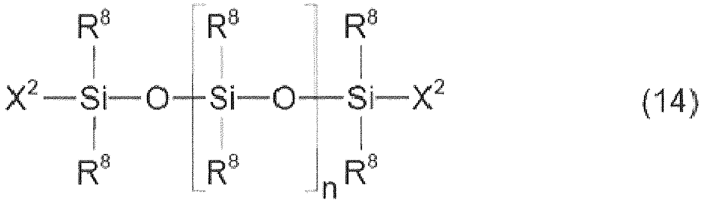 (where, in formula, R⁸ represents a monovalent hydrocarbon group selected from a saturated hydrocarbon group and an aromatic hydrocarbon group; X² represents a condensable substituted group; and "n" represents an integer of 1 or more.)

In formula (14), an example of the monovalent hydrocarbon group represented by R⁸ includes the monovalent hydrocarbon group illustrated by R⁶ in the above-described formula (10). Preferably, methyl and phenyl are used.

In formula (14), an example of the condensable substituted group represented by X² includes the condensable substituted group illustrated by R⁶ in the above-described formula (10). Preferably, a hydroxyl group and a hydrogen atom are used, or more preferably, a hydroxyl group is used.

When the condensable substituted group is a hydroxyl group, the dual-end type polysiloxane is defined as a polysiloxane containing silanol groups at both ends (a silicone oil containing silanol groups at both ends) represented by the following formula (15). 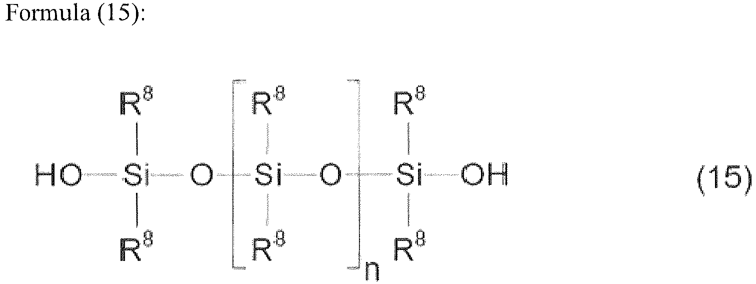 (where, in formula, R⁸ represents a monovalent hydrocarbon group selected from a saturated hydrocarbon group and an aromatic hydrocarbon group. "n" represents an integer of 1 or more.)

R⁸ is the same as that described above.

In the above-described formulas (14) and (15), "n" is, in view of stability and/or handling ability, preferably an integer of 1 to 10000, or more preferably an integer of 1 to 1000.

To be specific, examples of the dual-end type polysiloxane include a polydimethylsiloxane containing silanol groups at both ends, a polymethylphenylsiloxane containing silanol groups at both ends, and a polydiphenylsiloxane containing silanol groups at both ends.

A commercially available product can be used as the second silicon compound and a second silicon compound synthesized in accordance with a known method can be also used.

The number average molecular weight of the second silicon compound is, in view of stability and/or handling ability, for example, 100 to 1000000, or preferably 200 to 100000. The number average molecular weight is calculated by conversion based on standard polystyrene with a gel permeation chromatography. The number average molecular weight of materials, other than the second silicon compound, to be described later, is also calculated in the same manner as described above.

In order to allow the first silicon compound and the second silicon compound to be partially subjected to condensation, a condensation material made of those is blended with a condensation catalyst.

The mixing ratio of the second silicon compound with respect to 100 parts by mass of the total amount of the first silicon compound and the second silicon compound (that is, the total amount of the condensation material) is, for example, 1 to 99.99 parts by mass, preferably 50 to 99.9 parts by mass, or more preferably 80 to 99.5 parts by mass.

The molar ratio (X²/X¹) of the condensable substituted group (X² in the above-described formula (14), to be specific, a hydroxyl group) in the second silicon compound to the condensable substituted group (X¹ in the above-described formula (11), to be specific, an alkoxy group) in the first silicon compound is, for example, 20/1 to 1/5, preferably 10/1 to 1/2, or more preferably substantially 1/1.

When the molar ratio is above the above-described upper limit, in a case where the first polysiloxane is obtained by allowing the first and the second silicon compounds to be partially subjected to condensation and thereafter, the first and the second polysiloxanes are completely subjected to condensation, a silicone semi-cured material (a semi-cured material sheet or the like, described later) having an appropriate toughness may not be obtained. On the other hand, when the molar ratio is below the above-described lower limit, the mixing proportion of the first silicon compound is excessively large, so that the heat resistance of a silicone cured material to be obtained may be reduced.

When the molar ratio is within the above-described range (preferably, substantially 1/1), the condensable substituted group (to be specific, an alkoxy group) in the first silicon compound and the condensable substituted group (to be specific, a hydroxyl group) in the second silicon compound can be completely subjected to condensation neither too much nor too little.

When the trifunctional silicon compound and the bifunctional silicon compound are used in combination, the ratio (the number of parts by mass of the bifunctional silicon compound/the number of parts by mass of the trifunctional silicon compound) of the bifunctional silicon compound to the trifunctional silicon compound is, for example, 70/30 to 1/99, or preferably 50/50 to 5/95 based on mass. When the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (12), to be specific, an alkoxy group) in the trifunctional silicon compound is, for example, 20/1 to 1/5, preferably 10/1 to 1/2, or more preferably substantially 1/1. On the other hand, when the trifunctional silicon compound and the bifunctional silicon compound are used in combination, the molar ratio (X²/X¹) of the condensable substituted group (X² in the above-described formula (14), to be specific, a hydroxyl group) in the second silicon compound to the condensable substituted group (X¹ in the above-described formula (13), to be specific, an alkoxy group) in the bifunctional silicon compound is, for example, 20/1 to 1/5, preferably 10/1 to 1/2, or more preferably substantially 1/1.

The condensation catalyst is not particularly limited as long as it is a catalyst that promotes condensation of the first silicon compound with the second silicon compound. Examples of the condensation catalyst include an acid, a base, and a metal catalyst.

An example of the acid includes an inorganic acid (a Broensted acid) such as a hydrochloric acid, an acetic acid, a formic acid, and a sulfuric acid. The acid includes a Lewis acid and an example of the Lewis acid includes an organic Lewis acid such as pentafluorophenyl boron, scandium triflate, bismuth triflate, scandium trifurylimide, oxovanadium triflate, scandium trifurylmethide, and trimethylsilyl trifurylimide.

Examples of the base include an inorganic base such as potassium hydroxide, sodium hydroxide, and potassium carbonate and tetramethylammonium hydroxide. Preferably, an organic base such as tetramethylammonium hydroxide is used.

Examples of the metal catalyst include an aluminum-based catalyst, a titanium-based catalyst, a zinc-based catalyst, and a tin-based catalyst. Preferably, a tin-based catalyst is used.

Examples of the tin-based catalyst include a carboxylic acid tin salt such as di (or bis)(carboxylic acid)tin (II) containing a straight chain or branched chain carboxylic acid having 1 to 20 carbon atoms including di(2-ethylhexanoate)tin (II), dioctanoate tin (II) (dicaprylic acid tin (II)), bis(2-ethylhexanoate)tin, bis(neodecanoate)tin, and tin oleate and an organic tin compound such as dibutylbis(2,4-pentanedionate)tin, dimethyltindiversatate, dibutyltindiversatate, dibutyltindiacetate (dibutyldiacetoxytin), dibutyltindioctoate, dibutylbis(2-ethylhexylmaleate)tin, dioctyldilauryltin, dimethyldineodecanoatetin, dibutyltindioleate, dibutyltindilaulate, dioctyltindilaulate, dioctyltindiversatate, dioctyltinbis (mercaptoacetic acid isooctyl ester)salt, tetramethyl-1,3-diacetoxydistannoxane, bis(triethyltin)oxide, tetramethyl-1,3-diphenoxydistannoxane, bis(tripropyltin)oxide, bis(tributyltin)oxide, bis(tributyltin)oxide, bis(triphenyltin)oxide, poly(dibutyltin maleate), diphenyltindiacetate, dibutyltin oxide, dibutyltindimethoxide, and dibutylbis(triethoxy)tin.

As the tin-based catalyst, preferably, a carboxylic acid tin salt is used, more preferably, di(carboxylic acid)tin (II) containing a straight chain or branched chain carboxylic acid having 1 to 20 carbon atoms is used, further more preferably, di(carboxylic acid)tin (II) containing a straight chain or branched chain carboxylic acid having 4 to 14 carbon atoms is used, or particularly preferably, di(carboxylic acid)tin (II) containing a branched chain carboxylic acid having 6 to 10 carbon atoms is used.

These condensation catalysts can be used alone or in combination.

A commercially available product can be used as the condensation catalyst. A condensation catalyst synthesized in accordance with a known method can be also used.

The condensation catalyst can be, for example, solved in a solvent to be prepared as a condensation catalyst solution. The concentration of the condensation catalyst in the condensation catalyst solution is adjusted to be, for example, 1 to 99 mass %.

The mixing ratio of the condensation catalyst with respect to 100 mol of the second silicon compound is, for example, 0.001 to 50 mol, or preferably 0.01 to 5 mol.

Next, in this method, after the blending of the first silicon compound, the second silicon compound, and the condensation catalyst, the mixture is stirred and mixed at a temperature of, for example, 0 to 80°C, or preferably 10 to 75°C for, for example, 1 minute to 24 hours, or preferably 2 to 10 hours.

By the above-described mixing, the first and the second silicone compounds are partially subjected to condensation in the presence of the condensation catalyst.

To be specific, the condensable substituted group (X¹ in the above-described formula (11)) in the first silicon compound and the condensable substituted group (X² in the above-described formula (14)) in the second silicon compound are partially subjected to condensation.

To be more specific, when the condensable substituted group in the first silicon compound is an alkoxy group and the condensable substituted group in the second silicon compound is a hydroxyl group, as shown by the following formula (16), they are partially subjected to condensation.

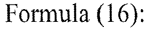

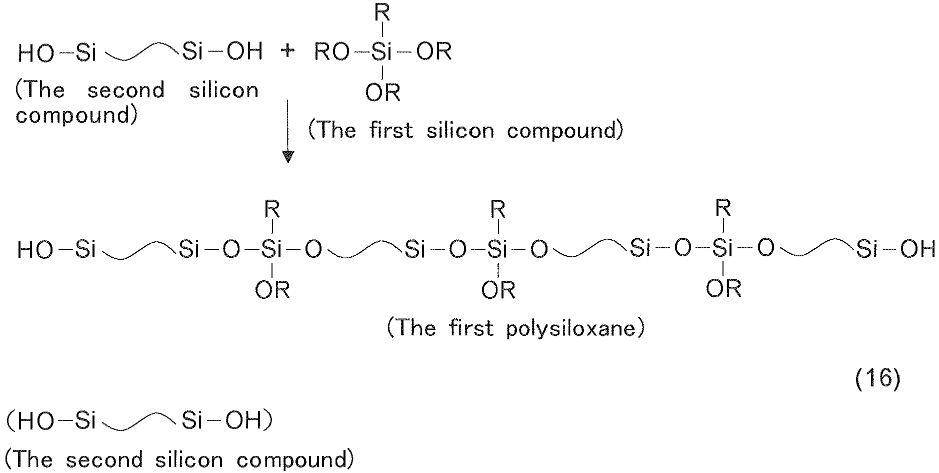

A portion in the second silicon compound is not subjected to condensation and remains to be subjected to condensation with the condensable substituted group in the first polysiloxane by next further condensation (a complete curing step).

The first polysiloxane obtained in this way is in a liquid state (in an oil state) and in an A-stage state.

An example of the second polysiloxane includes a side-chain type polysiloxane that is represented by the following formula (17) and contains at least one condensable substituted group in a side chain.

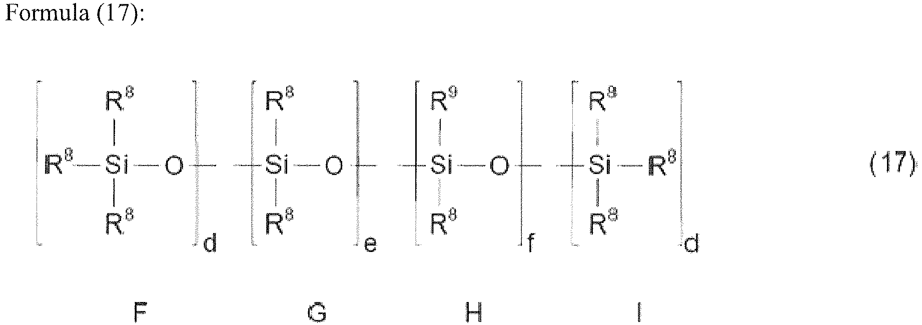

(where, in formula, F to I represent a constituent unit; F and I represent an end unit; and G and H represent a repeating unit. R⁸ represents a monovalent hydrocarbon group selected from a saturated hydrocarbon group and an aromatic hydrocarbon group, and R⁹ or SiR⁹ represents an addable substituted group. "d" is 0 or 1, "e" is an integer of 0 or more, and "f' is an integer of 1 or more. All of the R⁸s or the R⁹s may be the same or different from each other.)

In formula (17), an example of the monovalent hydrocarbon group represented by R⁸ includes the monovalent hydrocarbon group illustrated by R⁶ in the above-described formula (10). Preferably, methyl and phenyl are used.

In formula (17), as the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

When "d" is 1, the side-chain type polysiloxane is a straight chain polysiloxane and when "d" is 0, the side-chain type polysiloxane is a cyclic polysiloxane.

Preferably, "d" is 1.

"e" represents the number of repeating unit in the constituent unit G and is, in view of reactivity, preferably an integer of 0 to 100000, or more preferably an integer of 1 to 10000.

"f" represents the number of repeating unit in the constituent unit H and is, in view of reactivity, preferably an integer of 1 to 100000, or more preferably an integer of 2 to 10000.

The number average molecular weight of the side-chain type polysiloxane is, for example, in view of stability and handling ability, 100 to 1000000, or preferably 100 to 100000.

To be specific, examples of the side-chain type polysiloxane include a methylhydrogenpolysiloxane, a methylvinylpolysiloxane, a dimethylpolysiloxane-co-methylhydrogenpolysiloxane, a dimethylpolysiloxane-co-vinylmethylpolysiloxane, an ethylhydrogenpolysiloxane, a methylhydrogenpolysiloxane-co-methylphenylpolysiloxane, a methylvinylpolysiloxane-co-methylphenylpolysiloxane, a 2,4,6,8-tetramethyl-2,4,6,8-tetravinylcyclotetrasiloxane, and a 1,3,5,7-tetramethylcyclotetrasiloxane.

These side-chain type polysiloxanes can be used alone or in combination of two or more.

Preferably, a straight chain side-chain type polysiloxane in which R⁸ is a methyl group; R⁹ is a hydrogen atom (that is, SiR⁹ is a hydrosilyl group) or a vinyl group; "d" is 1; "e" is an integer of 1 or more; and "h" is an integer of 2 or more is used.

An example of the second polysiloxane includes a dual-end type polysiloxane (a polysiloxane containing addable substituted groups at both ends) that is represented by the following formula (18) and contains the addable substituted groups at both ends of a molecule. 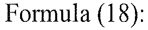 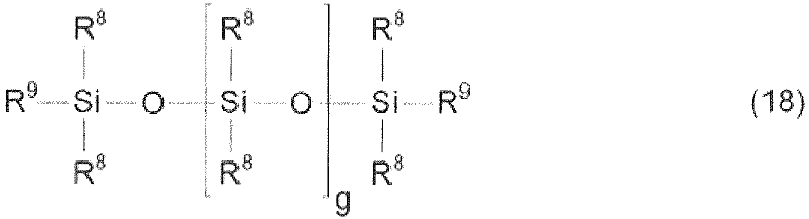 (where, in formula, R⁸ represents a monovalent hydrocarbon group selected from a saturated hydrocarbon group and an aromatic hydrocarbon group; R⁹ or SiR⁹ represents an addable substituted group; and "g" represents an integer of 1 or more. All of the R⁸s or the R⁹s may be the same or different from each other.)

An example of the monovalent hydrocarbon group represented by R⁸ includes the monovalent hydrocarbon group illustrated by R⁶ in the above-described formula (10). Preferably, methyl and phenyl are used.

As the addable substituted group represented by R⁹ or SiR⁹, for example, the above-described addable substituted group is used; preferably, the other of the substituted groups constituting one pair of addable substituted groups is used; more preferably, a hydrosilyl group and an ethylenically unsaturated group-containing group (to be specific, a vinyl group) are used; or further more preferably, a hydrosilyl group is used.

"g" is, in view of reactivity, preferably an integer of 1 to 100000, or more preferably an integer of 2 to 10000.

The number average molecular weight of the dual-end type polysiloxane is, for example, in view of stability and handling ability, 100 to 1000000, or preferably 100 to 100000.

Examples of the dual-end type polysiloxane include a polydimethylsiloxane containing hydrosilyl groups at both ends, a polydimethylsiloxane containing vinyl groups at both ends, a polymethylphenylsiloxane containing hydrosilyl groups at both ends, a polymethylphenylsiloxane containing vinyl groups at both ends, a polydiphenylsiloxane containing hydrosilyl groups at both ends, a polydimethylsiloxane containing vinyl groups at both ends, and a polydiphenylsiloxane containing vinyl groups at both ends.

These dual-end type polysiloxanes can be used alone or in combination of two or more.

Preferably, a polydimethylsiloxane containing hydrosilyl groups at both ends (an organohydrogenpolysiloxane) or a polydimethylsiloxane containing vinyl groups at both ends in which all of the R⁸s are methyl groups; R⁹ is a hydrogen atom (that is, SiR⁹ is a hydrosilyl group) or a vinyl group; and "g" is an integer of 2 to 10000 is used.

Of the above-described side-chain type polysiloxane and dual-end type polysiloxane, as the second polysiloxane, preferably, a dual-end type polysiloxane is used.

A commercially available product can be used as the second polysiloxane. A second polysiloxane synthesized in accordance with a known method can be also used.

In order to prepare the first silicone resin composition, the first polysiloxane and the second polysiloxane are blended. Preferably, the first polysiloxane and the second polysiloxane are blended with an addition catalyst.

The molar ratio (R⁷/SiR⁹) of the addable substituted group (one side, preferably a vinyl group (R⁷ in formula (11)) in the first polysiloxane to the addable substituted group (the other side, preferably a hydrosilyl group (SiR⁹ in formula (18)) in the second polysiloxane is, for example, 20/1 to 1/20, preferably 20/1 to 1/10, more preferably 10/1 to 1/10, particularly preferably 10/1 to 1/5, or most preferably 5/1 to 1/5.

When the molar ratio is above the above-described mixing proportion, in a case where a silicone semi-cured material (a semi-cured material sheet) is obtained, the silicone semi-cured material having an appropriate toughness may not be obtained. On the other hand, when the molar ratio is below the above-described mixing proportion, the mixing proportion of the second polysiloxane is excessively large, so that the heat resistance and the toughness of the silicone cured material to be obtained may be insufficient.

The mixing ratio of the second polysiloxane with respect to 100 parts by mass of the total amount of the first polysiloxane and the second polysiloxane is, for example, 1 to 99.99 parts by mass, preferably 50 to 99.9 parts by mass, or more preferably, 80 to 99.5 parts by mass.

The addition catalyst is not particularly limited as long as it is a catalyst that promotes addition of the addable substituted group in the first polysiloxane with the addable substituted group in the first polysiloxane, to be specific, addition in the above-described formulas (6) to (9). Preferably, in view of promoting condensation by an active energy ray, a photocatalyst having active properties with respect to the active energy ray is used.

An example of the photocatalyst includes a hydrosilylation catalyst.

The hydrosilylation catalyst promotes a hydrosilylation addition reaction of a hydrosilyl group with an alkenyl group. An example of the hydrosilylation catalyst includes a transition element catalyst. To be specific, examples thereof include a platinum-based catalyst; a chromium-based catalyst (hexacarbonyl chromium (Cr(CO)₆ and the like); an iron-based catalyst (carbonyltriphenylphosphine iron (Fe(CO)PPh₃ and the like), tricarbonylbisphenylphosphine iron (trans-Fe(CO)₃(PPh₃)₂), polymer-substrate-(aryl-diphenylphosphine)5-n[carbonyl iron] (polymer substrate-(Ar-PPh₂)₅-n[Fe(CO)ₙ]), pentacarbonyl iron (Fe(CO)₅), and the like); a cobalt-based catalyst (tricarbonyltriethylsilylcobalt (Et₃SiCo(CO)₃), tetracarbonyltriphenylsilylcobalt (Ph₃SiCo(CO)₄), octacarbonylcobalt (Co₂(CO)₈), and the like); a molybdenum-based catalyst (hexacarbonylmolybdenum (Mo(CO)₆ and the like); a palladium-based catalyst; and a rhodium-based catalyst.

As the hydrosilylation catalyst, preferably, a platinum-based catalyst is used. Examples thereof include inorganic platinum such as platinum black, platinum chloride, and chloroplatinic acid and a platinum complex such as a platinum olefin complex, a platinum carbonyl complex, a platinum cyclopentadienyl complex, and a platinum acetylacetonate complex.

Preferably, in view of reactivity, a platinum complex is used, or more preferably, a platinum cyclopentadienyl complex and a platinum acetylacetonate complex are used.

Examples of the platinum cyclopentadienyl complex include trimethyl (methylcyclopentadienyl) platinum (IV) and a trimethyl (cyclopentadienyl) platinum (IV) complex.

An example of the platinum acetylacetonate complex includes 2,4-pentanedionato platinum (II) (platinum (II) acetylacetonate).

An example of the transition element catalyst can also include one described in the following document.

Document: ISSN 1070-3632, Russian Journal of General Chemistry, 2011, Vol.81, No.7, pp. 1480 to 1492, "Hydrosilylation on Photoactivated Catalysts", D.A. de Vekki

These addition catalysts can be used alone or in combination.

A commercially available product can be used as the addition catalyst. An addition catalyst synthesized in accordance with a known method can be also used.

The addition catalyst can be, for example, solved in a solvent to be prepared as an addition catalyst solution. The concentration of the addition catalyst in the addition catalyst solution is, for example, 1 to 99 mass %. When the addition catalyst is a transition element catalyst, the concentration of the transition element is adjusted to be, for example, 0.1 to 50 mass %.

The mixing ratio of the addition catalyst with respect to 100 parts by mass of the total of the first silicone resin composition is, for example, 1.0 × 10⁻¹¹ to 0.5 parts by mass, or preferably, 1.0 × 10⁻⁹ to 0.1 parts by mass.

The addition catalyst can be also used in combination with a photoassistance agent such as a photoactive agent, a photoacid generator, and a photobase generator with an appropriate amount as required.

The photoactive agent can be used in combination with the addition catalyst as required. Examples of the photoactive agent include a photo-radical initiator, a cationic initiator, and an anionic initiator. Preferably, a photo-radical initiator is used. Examples of the photo-radical initiator include an alkylphenone-based photo-radical initiator such as 2,2-dimethoxy-1,2-diphenylethane-1-one, 1-hydroxycyclohexylphenylketone, 2-hydroxy-2-methyl-1-phenylpropane-1-one, 1-[4-(2-hydroxyethoxy)phenyl]-2-hydroxy-2-methyl-1-propane-1-one, 2-hydroxy-1-{4-[4-(2-hydroxy-2-methylpropionyl)benzyl]phenyl}-2-methylpropane-1-one, 2-methyl-1-(4-methylphenyl)-2-morpholinopropane-1-one, 2-benzyl-2-dimethylamino-1-(4-morpholinophenyl)butanone-1, 2-(dimethylamino)-2-[(4-methylphenyl)methyl]-1-[4-(4-morpholinyl)phenyl]-1-butanone, and oligo{2-hydroxy-2-methyl-[4-(1-methylvinyl)phenyl]}propanone and an acyl phosphine oxide-based photo-radical initiator such as 2,4,6-trimethylbenzoylphenylphosphine oxide and bis(2,4,6-trimethylbenzoyl)phenylphosphine oxide. These photoactive agents can be used alone or in combination.

The photoacid generator is used in combination with the addition catalyst as required. Examples of the photoacid generator include a sulfonium salt compound such as triphenylsulfonium trifluoromethanesulfonate, triphenylsulfonium trifluoromethaneantimonate, triphenylsulfonium benzosulfonate, cyclohexylmethyl(2-oxocyclohexyl)sulfonium trifluoromethanesulfonate, dicyclohexyl(2-oxocyclohexyl)sulfonium trifluoromethanesulfonate, dicyclohexylsulfonylcyclohexanone, and dimethyl(2-oxocyclohexyl)sulfonium trifluoromethanesulfonate; an iodonium salt such as diphenyliodonium trifluoromethanesulfonate; and N-hydroxysuccinimide trifluoromethanesulfonate. These photoacid generators can be used alone or in combination.

The photobase generator can be used in combination with the addition catalyst as required. Examples of the photobase generator include a cobalt amine complex, o-acyloxime, a carbamic acid derivative, a formamide derivative, quaternary ammonium salt, tosylamine, carbamate (for example, 2-nitrobenzyl carbamate, 2,5-dinitrobenzylcyclohexyl carbamate, and 1,1-dimethyl-2-phenylethyl-N-isopropyl carbamate), an amineimide compound, and a sulfonamide compound (for example, N-cyclohexyl-4-methylphenylsulfonamide). These photobase generators can be used alone or in combination.

Each of the components containing the first polysiloxane and the second polysiloxane is blended at the above-described mixing proportion to be stirred and mixed, so that the first silicone resin composition can be obtained.

The first silicone resin composition contains a part of the second silicon compound that remains in the preparation of the first polysiloxane.

A filler and furthermore, an additive can be added to the first silicone resin composition at an appropriate proportion as required. Examples of the additive include an antioxidant, a modifier, a surfactant, a dye, a pigment, a discoloration inhibitor, an ultraviolet absorber, an anti-crepe hardening agent, a plasticizer, a thixotropic agent, and a fungicide.

Examples of the filler include silicon oxide (silica), aluminum oxide (alumina), titanium oxide, zirconium oxide, magnesium oxide, zinc oxide, iron oxide, aluminum hydroxide, calcium carbonate, layered mica, carbon black, diatomite, a glass fiber, silicone particles, an oxide phosphor (including an oxide phosphor activated by a lanthanoid element), an oxynitride phosphor (including an oxynitride phosphor activated by a lanthanoid element), a nitride phosphor (including a nitride phosphor activated by a lanthanoid element), a sulfide phosphor, and a silicate compound. As the filler, a filler to which surface treatment is applied with an organic silicon compound such as an organoalkoxysilane, an organochlorosilane, and an organosilazane is also used.

Preferably, an inorganic filler such as silica and a phosphor such as an oxide phosphor, an oxynitride phosphor, a nitride phosphor, and a sulfide phosphor are used.

As the phosphor, preferably, an oxide phosphor is used, or more preferably, a yellow phosphor such as Y₃Al₅O₁₂:Ce (YAG (yttrium aluminum garnet):Ce) and Tb₃Al₃O₁₂:Ce (TAG (terbium aluminum garnet):Ce) is used. Also, as the phosphor, preferably, an oxynitride phosphor is used, or more preferably, Ca-α-SiAlON (for example, α-SiAlON) is used.

The shape of the filler is not particularly limited and examples of the shape thereof include a sphere shape and a pulverized shape. The average particle size of the filler is, for example, 70 µm or less, or preferably, in view of strength, 0.1 nm to 50 µm.

The mixing ratio of the filler with respect to 100 parts by mass of the total amount of the first and the second polysiloxanes is, in view of improving tensile elastic modulus and in view of light transmission properties, for example, 5 to 80 parts by mass.

The first silicone resin composition obtained as described above is, for example, in a liquid state, or preferably, in an oil state (in a viscous liquid state). The viscosity (described in detail in Examples later) thereof under conditions of 25°C and one pressure is, for example, 100 to 100000 mPa·s, or preferably 1000 to 50000 mPa·s.

Next, a method for obtaining a silicone cured material from the first silicone resin composition is described.

In this method, first, the first silicone resin composition is heated to obtain a silicone semi-cured material (a semi-curing step) and thereafter, an active energy ray is applied to the silicone semi-cured material to be cured (a complete curing step).

In the semi-curing step, for example, the first silicone resin composition is applied to the surface of a release sheet to form a film.

Examples of the release sheet include a polymer film such as a polyethylene film and a polyester film, a ceramic sheet, and a metal foil. Preferably, a polymer film is used. Release treatment such as fluorine treatment can be also applied to the surface of the release sheet.

In the application of the first silicone resin composition, for example, a casting, a spin coating, or a roll coating is used.

The thickness of the film is, for example, 10 to 5000 µm, or preferably 100 to 2000 µm.

In the semi-curing step, thereafter, the film is heated.

The heating conditions are as follows: a heating temperature of, for example, 40 to 180°C, or preferably 60 to 150°C and a heating duration of, for example, 0.1 to 180 minutes, or preferably 0.1 to 60 minutes.

When the heating conditions are within the above-described range, a low molecular weight component (for example, a solvent including water or the like) is surely removed to terminate condensation, so that the first silicone resin composition can be brought into a semi-cured state (a B-stage state).

In this way, the first silicone resin composition is semi-cured, so that a semi-cured material in a sheet shape, that is, a semi-cured material sheet is obtained (the semi-curing step).

The thickness of the semi-cured material sheet is, for example, 10 to 5000 µm, or preferably 100 to 2000 µm.

In the semi-curing step, at least one pair of condensable substituted groups contained in the first polysiloxane is subjected to condensation by heating. In this way, when the condensable substituted group in the first silicon compound is an alkoxy group and the condensable substituted group in the second silicon compound is a hydroxyl group, as shown in the following formula (19), the molecular weight of the first polysiloxane is increased, so that the first silicone resin composition is gelated. That is, the first silicone resin composition is brought into a semi-cured state (a B-stage state), so that a silicone semi-cured material is obtained.

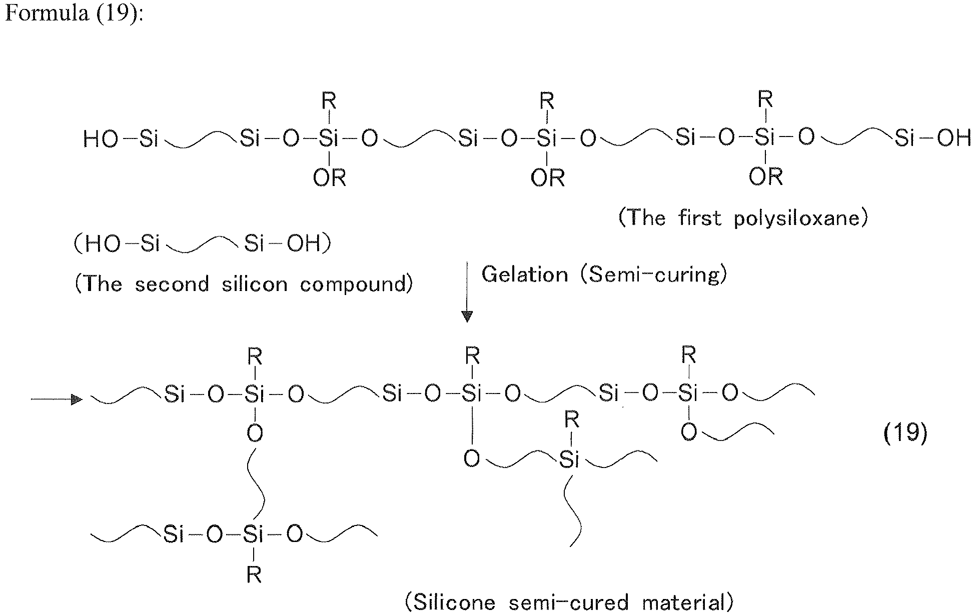

On the other hand, the first silicone resin composition is potted into a predetermined mold such as a cup to be thereafter heated, so that a silicone semi-cured material can be also obtained. The heating conditions are the same as those described above.

The tensile elastic modulus (a measurement temperature: 25°C) of the silicone semi-cured material (including a semi-cured material sheet) to be obtained is, for example, 0.001 to 0.5 MPa, or preferably 0.01 to 0.4 MPa.

Thereafter, the complete curing step is performed.

Examples of the active energy ray include an ultraviolet ray and an electron beam. An example of the active energy ray also includes an active energy ray having a spectral distribution in a wavelength region of, for example, 180 to 460 nm, or preferably 200 to 400 nm.

In the complete curing step, in the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 to 100 J/cm², or preferably 0.01 to 10 J/cm².

Furthermore, in the complete curing step, heating can be also performed. That is, in the complete curing step, the application of the active energy ray and the heating can be also used in combination.

The timing of the heating may be at the same time with the application of the active energy ray, or may be before or after the application of the active energy ray. Preferably, the heating is performed after the application of the active energy ray.

The heating conditions in the complete curing step are as follows: a heating temperature of, for example, 50 to 250°C, or preferably 100 to 200°C and a heating duration of, for example, 0.1 to 1440 minutes, or preferably 1 to 180 minutes.

In the complete curing step, by using the application of the active energy ray and the heating in combination, the curing in a short time, to be specific, the curing in a short time that is almost the same amount of time as in the case where the active energy ray is applied at a high amount of irradiation only can be performed, while the amount of irradiation of the active energy ray is suppressed.

In the complete curing step, by the application of the active energy ray (and the heating performed as required), as shown by the following formula (20), when the addable substituted group in the first polysiloxane is a vinyl group and the addable substituted group in the second polysiloxane is a hydrosilyl group, they are subjected to addition (hydrosilylation addition). In this way, the semi-cured material in the first silicone resin composition is completely cured. That is, a silicone cured material made of the first silicone resin composition is obtained.

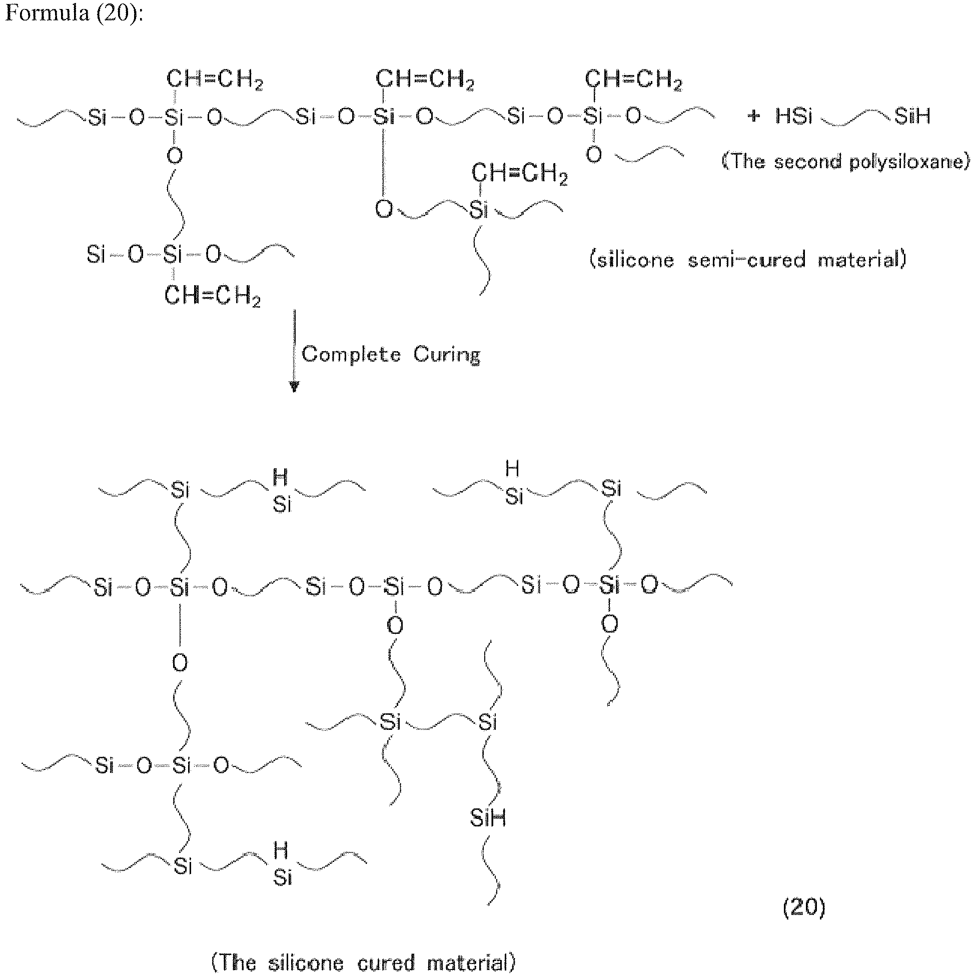

The degree of progress of the addition in the complete curing step can be checked with a peak strength derived from the addable substituted group by, for example, a solid NMR measurement.

The transmittance of the silicone cured material, in the case of a sheet shape having a thickness of 500 µm (that is, in the case of an encapsulating sheet), is, for example, 90 % or more, preferably 95 % or more, or more preferably above 99 % with respect to light at a wavelength of 450 nm.

In this method, the first silicone resin composition is heated to obtain the silicone semi-cured material (the semi-cured material sheet) and thereafter, the active energy ray is applied to the silicone semi-cured material (the semi-cured material sheet) to be cured, so that a duration required for the curing of the silicone semi-cured material (the semi-cured material sheet) can be shortened.

The silicone semi-cured material (the semi-cured material sheet) prepared from the above-described first silicone resin composition has excellent storability and stability. To be specific, the rate of change of the hardness before and after the storage for 24 hours at 25°C (the hardness after storage/the hardness of sheet immediately after preparation × 100) is, for example, 100 % or more and 150 % or less.

Furthermore, the silicone semi-cured material (the semi-cured material sheet) has excellent durability such as heat resistance.

<Second Silicone Resin Composition>

The second silicone resin composition contains a third polysiloxane containing at least one pair of condensable substituted groups that is capable of condensation by heating and at least one pair of addable substituted groups that is capable of addition by an active energy ray.

An example of the one pair of condensable substituted groups includes the same one pair of condensable substituted groups as that in the first polysiloxane in the first silicone resin composition. The one pair of condensable substituted groups is replaced with the end and the middle of the main chain and/or a side chain in the third polysiloxane.

An example of the one pair of addable substituted groups includes the same one pair of addable substituted groups as that in the first and the second polysiloxanes in the first silicone resin composition. The one pair of addable substituted groups is replaced with the end and the middle of the main chain and/or a side chain in the third polysiloxane.

The third polysiloxane is represented by, for example, the following formula (21). 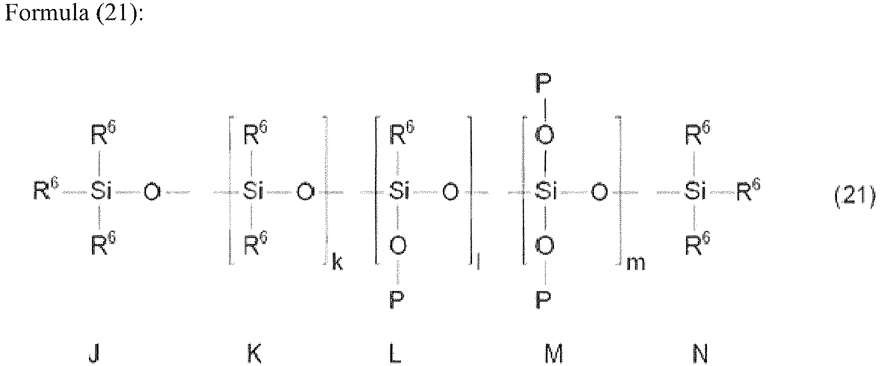 (where, in formula, R⁶ represents a monovalent hydrocarbon group selected from a saturated hydrocarbon group and an aromatic hydrocarbon group; a condensable substituted group; and/or an addable substituted group. J to N represent a constituent unit, J and N represent an end unit, and K to M represent a repeating unit. P represents a constituent unit of K to M. "k" + "l" + "m" is an integer of 1 or more. R⁶ contains at least one pair of condensable substituted groups and at least one pair of addable substituted groups.)

Examples of the monovalent hydrocarbon group, the condensable substituted group, and the addable substituted group represented by R⁶ include the monovalent hydrocarbon group, the condensable substituted group, and the addable substituted group illustrated in the above-described formula (10), respectively.

"k" + "l" + "m" is, in view of stability and handling ability, preferably an integer of 1 to 100000, or more preferably an integer of 1 to 10000.

"k" is, for example, an integer of 0 to 100000, or preferably an integer of 1 to 10000.

"l" is, for example, an integer of 0 to 100000, or preferably an integer of 0 to 10000.

"m" is, for example, an integer of 0 to 100000, or preferably an integer of 0 to 10000.

The number average molecular weight of the third polysiloxane is, for example, 100 to 1000000, or preferably 200 to 100000.

A commercially available product can be used as the third polysiloxane. A third polysiloxane synthesized in accordance with a known method can be also used.

The content ratio of the third polysiloxane with respect to the second silicone resin composition is, for example, 60 mass % or more, or preferably 90 mass % or more, and is, for example, 100 mass % or less.

The above-described additive can be also blended in the second silicone resin composition at an appropriate proportion.

In order to obtain a silicone cured material from the second silicone resin composition, the same method as that for the first silicone resin composition, that is, the semi-curing step and the complete curing step are sequentially performed.

A method in which the second silicone resin composition is heated to obtain a silicone semi-cured material and thereafter, an active energy ray is applied to the silicone semi-cured material to be cured achieves the same function and effect as that in the above-described method in which the first silicone resin composition is heated to obtain a silicone semi-cured material and thereafter, an active energy ray is applied to the silicone semi-cured material to be cured.

The second silicone resin composition, as a silicone material of one-liquid type, can be easily used, compared to the second silicone resin composition of two-liquid type.

<Light Emitting Diode Device>

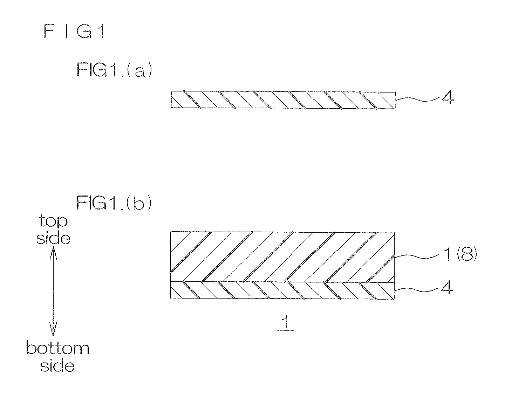

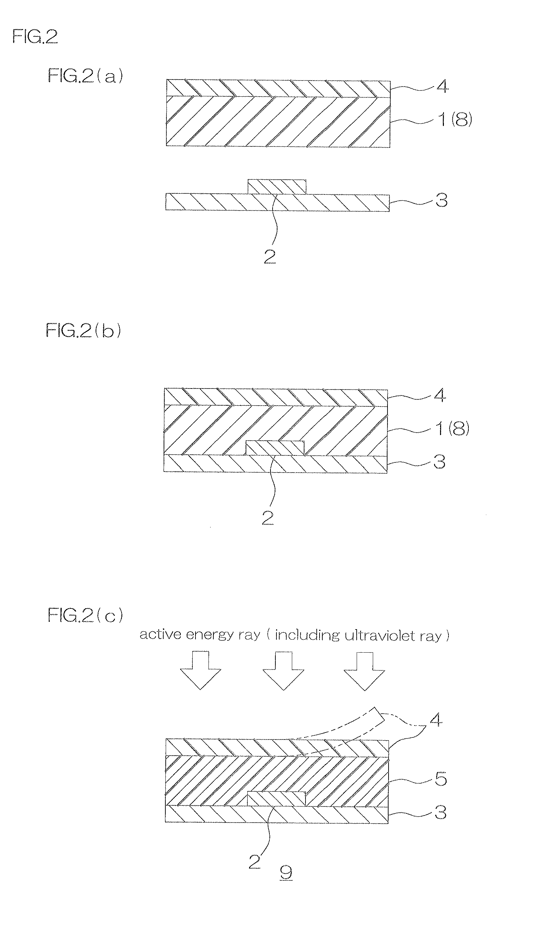

FIG. 1 shows process drawings for preparing an encapsulating sheet that is one embodiment of a semi-cured material sheet of the present invention: FIG. 1 (a) illustrating a step of preparing a release sheet and FIG. 1 (b) illustrating a step of forming the encapsulating sheet. FIG. 2 shows process drawings for illustrating one embodiment of a method for producing a light emitting diode device of the present invention: FIG. 2 (a) illustrating a step of disposing an encapsulating sheet in opposed relation to a board, FIG. 2 (b) illustrating a step of embedding a light emitting diode element by the encapsulating sheet, and FIG. 2 (c) illustrating a step of encapsulating the light emitting diode element by an encapsulating layer made of a silicone cured material by applying an ultraviolet ray to the encapsulating sheet.

Next, a method for producing a light emitting diode device 9 using an encapsulating sheet 1 made of a semi-cured material sheet 8 that is prepared from a silicone resin composition is described with reference to FIGS. 1 and 2.

First, in this method, as shown in FIGS. 1 (a) and 1 (b), the encapsulating sheet 1 is prepared.

In order to prepare the encapsulating sheet 1, first, as shown in FIG. 1 (a), a release sheet 4 is prepared.

Next, as shown in FIG. 1 (b), the above-described silicone resin composition in an A-stage state (including the first and the second silicone resin compositions) is applied to the surface of the release sheet 4 by the above-described application method to form a film and subsequently, the film is heated under the above-described heating conditions, so that the semi-cured material sheet 8 is formed.

The semi-cured material sheet 8 is prepared as the encapsulating sheet 1.

The thickness of the encapsulating sheet 1 is, for example, 10 to 5000 µm, or preferably 100 to 2000 µm.

Next, as shown in FIG. 2 (a), a board 3 mounted with a light emitting diode element 2 is prepared. To be specific, the light emitting diode element 2 is mounted on the board 3 (a mounting step).

The board 3 is formed into a generally flat plate shape. To be specific, the board 3 is formed of a laminated board in which a conductive layer (not shown) including an electrode pad (not shown) and a wire (not shown), as a circuit pattern, is laminated on an insulating board. The insulating board is, for example, formed of a silicon board, a ceramic board, or a polyimide resin board. Preferably, the insulating board is formed of a ceramic board, to be specific, a sapphire (Al₂O₃) board.

The conductive layer is formed of a conductor such as gold, copper, silver, or nickel. The thickness of the board 3 is, for example, 30 to 1500 µm, or preferably 500 to 1000 µm.

The light emitting diode element 2 is provided on the surface of the board 3 and is formed into a generally rectangular shape in sectional view. The light emitting diode element 2 is flip-chip mounting connected or wire bonding connected to an electrode pad in the board 3 to be electrically connected to the electrode pad. The light emitting diode element 2 is an element that emits blue light.

Next, as shown in FIG. 2 (a), the top and the bottom of the encapsulating sheet 1 shown in FIG. 1 (b) are reversed to be disposed in opposed relation to the top side of the board 3.

Next, as shown in FIG. 2 (b), the light emitting diode element 2 is embedded by the encapsulating sheet 1 (an embedding step).

To be specific, the encapsulating sheet 1 is compressively bonded to the board 3.

The pressure in the compressive bonding is, for example, 0.1 to 10 MPa, or preferably 0.5 to 5 MPa.

The surface of the light emitting diode element 2 is covered with the encapsulating sheet 1 by the compressive bonding (a covering step). A portion on the surface of the board 3 that is exposed from the light emitting diode element 2 is covered with the encapsulating sheet 1.

Thereafter, as shown by arrows in FIG. 2 (c), an active energy ray is applied to the encapsulating sheet 1. To be specific, the active energy ray is applied to the encapsulating sheet 1 from the top side of the encapsulating sheet 1, that is, from the side of the release sheet 4, to be more specific, so as to pass through the release sheet 4. The amount of irradiation is the same as that described above. Preferably, in view of suppressing the amount of irradiation so as to suppress a damage to the light emitting diode element 2 and/or the board 3 caused by the excessive application of the active energy ray, the amount of irradiation is 0.01 to 10 J/cm².

The application of the active energy ray and the heating are used in combination based on the same conditions as those described above as required.

In this way, the encapsulating sheet 1 is brought into a silicone cured material and the silicone cured material is formed as an encapsulating layer 5 that encapsulates the light emitting diode element 2 (an encapsulating step).

In this way, the light emitting diode device 9 in which the light emitting diode element 2 is encapsulated by the encapsulating layer 5 is obtained.

Thereafter, as shown by phantom lines in FIG. 2 (c), the release sheet 4 is peeled from the encapsulating layer 5.

According to this method, the light emitting diode element 2 is embedded by the semi-cured material sheet 8 obtained by heating the silicone resin composition containing the first and the second silicone resin compositions and thereafter, the active energy ray is applied to the semi-cured material sheet 8 to be cured. Thus, while the light emitting diode element 2 is embedded by an easy method, the encapsulating layer 5 made of the silicone cured material is easily and rapidly formed and a duration required for the step of encapsulating the light emitting diode element 2 by the encapsulating layer 5 can be shortened, so that the production efficiency of the light emitting diode device 9 is excellent.

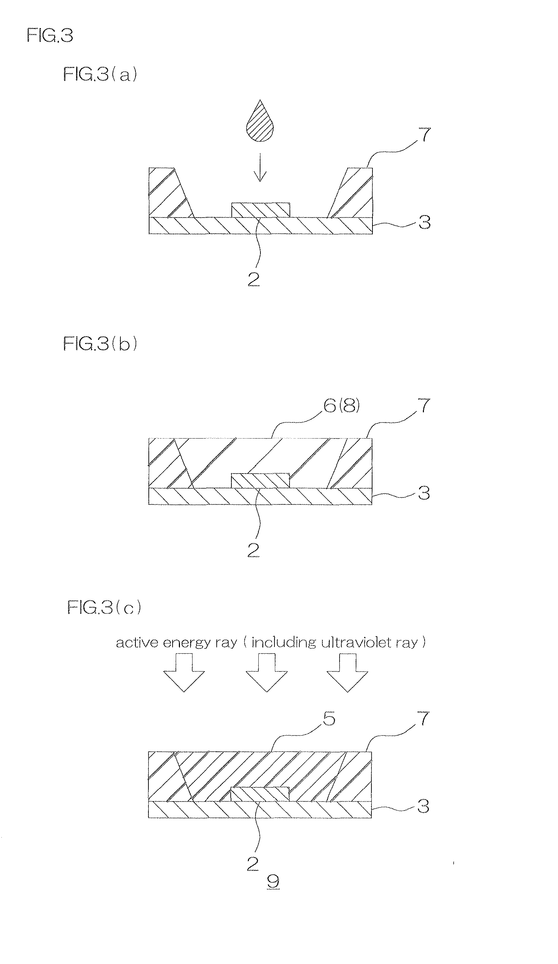

FIG. 3 shows process drawings for illustrating another embodiment of a method for producing a light emitting diode device of the present invention: FIG. 3 (a) illustrating a step of preparing a board provided with a reflector, FIG. 3 (b) illustrating a step of potting a silicone resin composition into the reflector to be subsequently semi-cured by heating, and FIG. 3 (c) illustrating a step of encapsulating a light emitting diode element by an encapsulating layer made of a silicone cured material by applying an ultraviolet ray to a semi-cured layer.

In FIG. 3, the same reference numerals are provided for members corresponding to each of those described above, and their detailed description is omitted.

In the embodiments in FIGS. 1 and 2, first, the encapsulating sheet 1 made of a silicone semi-cured material in a B-stage state is prepared and thereafter, the light emitting diode element 2 is embedded by the encapsulating sheet 1. Alternatively, for example, as shown in FIGS. 3 (a) and 3(b), a silicone resin composition in an A-stage state is potted with respect to the light emitting diode element 2 and thereafter, the silicone resin composition can be also semi-cured (brought into a B-stage state).

To be specific, in the embodiment in FIG. 3, first, as shown in FIG. 3 (a), the board 3 that is provided with a reflector 7 is prepared. To be specific, the light emitting diode element 2 is mounted on the board 3 that is provided with the reflector 7 (a mounting step).

The reflector 7 is provided so as to surround the light emitting diode element 2 and is formed into a generally rectangular frame shape or a generally ring shape (a circular ring shape or an elliptical ring shape) having its center open in plane view. The reflector 7 is also formed into a generally trapezoidal shape in which its width is gradually reduced toward the upper side in sectional view. The reflector 7 is disposed at the outer side of the light emitting diode element 2 at spaced intervals thereto. In this way, the light emitting diode element 2 is disposed in the reflector 7.

Next, as shown by the arrow in FIG. 3 (a), and in FIG. 3 (b), the silicone resin composition is potted into the reflector 7. To be specific, the silicone resin composition is potted thereinto so that the liquid surface of the silicone resin composition is generally flush with the upper surface of the reflector 7 in the thickness direction.

Next, the silicone resin composition is semi-cured by heating. The heating conditions are the same as the above-described heating conditions.

In this way, a semi-cured layer 6 made of a silicone semi-cured material corresponding to the shape of the inner surface of the reflector 7, the surfaces of the light emitting diode element 2, and the surface of the board 3, which is exposed from the reflector 7 and the light emitting diode element 2, is formed. In this way, the light emitting diode element 2 is covered with the semi-cured layer 6 (a covering step).

Thereafter, as shown in FIG. 3 (c), the active energy ray is applied to the semi-cured layer 6 to be completely cured. The irradiation conditions are the same as the above-described irradiation conditions.

In this way, the encapsulating layer 5 that encapsulates the light emitting diode element 2 and is made of a silicone cured material is formed (an encapsulating step).

In the embodiment in FIG. 3, the same function and effect as those of the embodiments in FIGS. 1 and 2 can be achieved.

In the embodiment in FIG. 3, the silicone resin composition is potted into the reflector 7 without preparing the encapsulating sheet 1 that includes the release sheet 4, so that the step of preparing the release sheet 4 (ref: FIG. 1 (a)) can be omitted.

On the other hand, in the embodiments in FIGS. 1 and 2, the light emitting diode element 2 is embedded by the encapsulating sheet 1, so that the light emitting diode element 2 in the board 3 that is not provided with the reflector 7 (ref: FIG. 3 (a)) can be easily encapsulated.

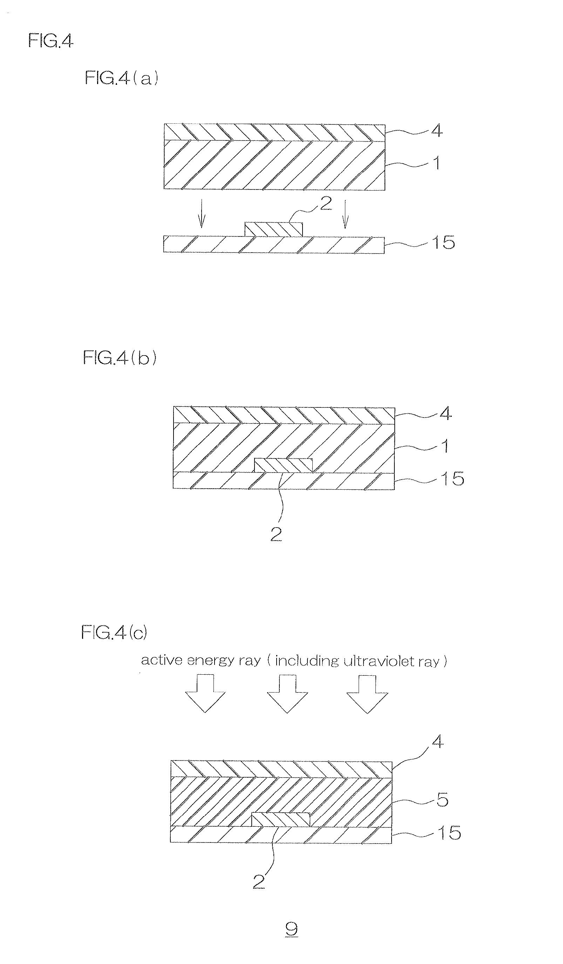

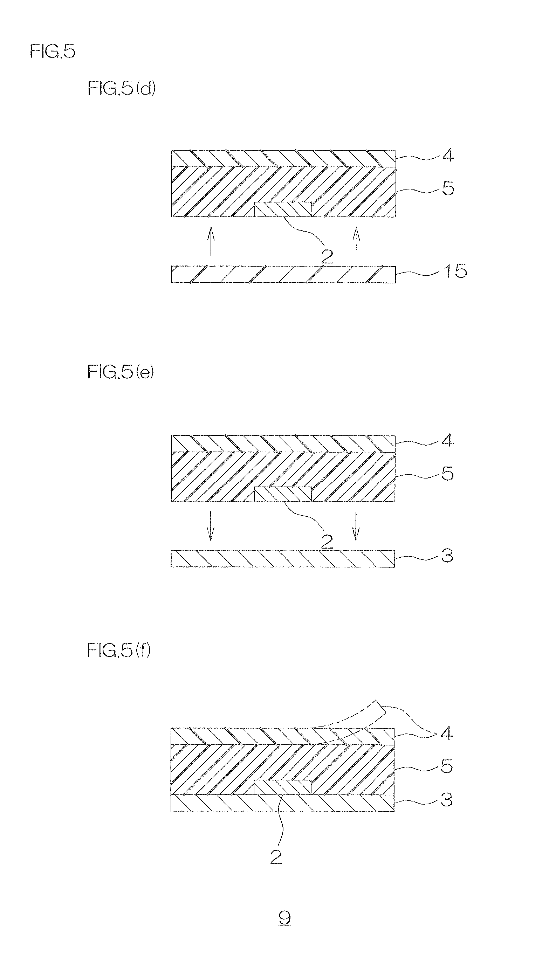

FIG. 4 shows process drawings for illustrating another embodiment of a method for producing a light emitting diode device of the present invention: FIG. 4 (a) illustrating a step of preparing a light emitting diode element supported by a support, FIG. 4 (b) illustrating a step of embedding the light emitting diode element by an encapsulating sheet, and FIG. 4 (c) illustrating a step of encapsulating the light emitting diode element by an encapsulating layer made of a silicone cured material by applying an ultraviolet ray to the encapsulating sheet. FIG. 5 shows process drawings for illustrating another embodiment of a method for producing a light emitting diode device of the present invention, subsequent to FIG. 4: FIG. 5 (d) illustrating a step of peeling the encapsulating layer and the light emitting diode element from the support, FIG. 5 (e) illustrating a step of disposing the encapsulating layer and the light emitting diode element in opposed relation to a board, and FIG. 5 (f) illustrating a step of mounting the light emitting diode element on the board.

In the above-described embodiments in FIGS. 2 and 3, first, the light emitting diode element 2 is mounted on the board 3 to be prepared in advance (the mounting step, ref: FIGS. 2 (a) and 3 (a)). Thereafter, the light emitting diode element 2 is embedded by and covered with the encapsulating sheet 1 (the embedding step and the covering step, ref: FIG. 2 (b)) or the light emitting diode element 2 is covered with the silicone resin composition (the covering step, ref: FIG. 3 (b)). After those steps, the light emitting diode element 2 is encapsulated (the encapsulating step, ref: FIGS. 2 (c) and 3 (c)). Alternatively, as shown in FIGS. 4 and 5, for example, first, the light emitting diode element 2 that is supported by a support 15 is prepared. Next, the light emitting diode element 2 is encapsulated by the encapsulating sheet 1 (an encapsulating step) and then, the encapsulating sheet 1 and the light emitting diode element 2 are peeled from the support 15. Thereafter, the light emitting diode element 2 can be mounted on the board 3 (a mounting step).

In this method, first, as shown in FIG. 4 (a), the light emitting diode element 2 that is supported by the support 15 is prepared.

An example of the support 15 includes a support sheet made of the same material as that of the release sheet 4. The thickness of the support 15 is, for example, 50 to 10000 µm, or preferably 500 to 5000 µm.

Next, as shown in FIG. 4 (b), the light emitting diode element 2 that is supported by the support 15 is embedded by the encapsulating sheet 1 (an embedding step). To be specific, the encapsulating sheet 1 is compressively bonded to the support 15.

Subsequently, as shown in FIG. 4 (c), an active energy ray is applied to the encapsulating sheet 1 to be completely cured. In this way, the encapsulating sheet 1 serves as the encapsulating layer 5 and the light emitting diode element 2 is encapsulated by the encapsulating layer 5 (an encapsulating step).

In FIG. 4 (c), the encapsulating layer 5 and the light emitting diode element 2 that is encapsulated by the encapsulating layer 5 are included in the light emitting diode device of the present invention.

Next, as shown in FIG. 5 (d), the light emitting diode element 2 and the encapsulating layer 5 are peeled from the support 15.

Next, as shown by the arrows in FIG. 5 (e), and in FIG. 5 (f), the light emitting diode element 2 that is encapsulated by the encapsulating layer 5 is mounted on the board 3 (a mounting step).

In this way, the light emitting diode device 9 including the light emitting diode element 2 that is encapsulated by the encapsulating layer 5 and is mounted on the board 3 is obtained.

Thereafter, as shown by the phantom lines in FIG. 5 (f), the release sheet 4 is peeled from the encapsulating layer 5 as required.

### Examples

While the present invention will be described hereinafter in further detail with reference to Examples and Comparative Example, the present invention is not limited to these Examples and Comparative Example.

### 1. <Preparation of Silicone Resin Composition>

### Example 1

(Use of Trifunctional Silicon Compound as First Silicon Compound)

After 100 g (8.70 mmol) of a silicone oil containing silanol groups at both ends (a polydimethylsiloxane containing silanol groups at both ends, manufactured by Shin-Etsu Chemical Co., Ltd., a number average molecular weight of 11500) and 0.86 g [5.80 mmol, the molar ratio (hydroxyl group/methoxy group) of the hydroxyl group in the silicone oil containing silanol groups at both ends to the methoxy group in the vinyltrimethoxysilane = 1/1] of a vinyltrimethoxysilane (manufactured by Shin-Etsu Chemical Co., Ltd.) were stirred and mixed, 0.074 g (0.17 mmol, 2.0 mol with respect to 100 mol of the silicone oil containing silanol groups at both ends) of di(2-ethylhexanoate) tin (II) (a concentration of 95 mass %) as a condensation catalyst was added thereto to be stirred at room temperature (at 25°C) for 5 hours. In this way, a first polysiloxane in an oil state was prepared.

Thereafter, 2.4 g [the molar ratio (vinyl group/hydrosilyl group) of the vinyl group in the vinyltrimethoxysilane to the hydrosilyl group in the organohydrogenpolysiloxane = 1/3] of an organohydrogenpolysiloxane (a second polysiloxane, a polydimethylsiloxane containing hydrosilyl groups at both ends, manufactured by Shin-Etsu Chemical Co., Ltd) and 0.075 mL (15 ppm to the total of the first silicone resin composition) of a solution of trimethyl (methylcyclopentadienyl) platinum (IV) (a platinum concentration of 2 mass %) as an addition catalyst (a hydrosilylation catalyst) were added to the first polysiloxane, so that a first silicone resin composition in an oil state and in an A-stage state was obtained.

### Example 2

(Use of Trifunctional Silicon Compound and Bifunctional Silicon Compound in Combination (50:50))

After 100 g (8.70 mmol) of a silicone oil containing silanol groups at both ends (a polydimethylsiloxane containing silanol groups at both ends, manufactured by Shin-Etsu Chemical Co., Ltd., a number average molecular weight of 11500); 0.43 g [2.9 mmol, the molar ratio (hydroxyl group/methoxy group) of the hydroxyl group in the silicone oil containing silanol groups at both ends to the methoxy group in the vinyltrimethoxysilane = 2/1] of a vinyltrimethoxysilane (manufactured by Shin-Etsu Chemical Co., Ltd.); and 0.58 g [4.3 mmol, the molar ratio (hydroxyl group/methoxy group) of the hydroxyl group in the silicone oil containing silanol groups at both ends to the methoxy group in the vinyldimethoxymethylsilane = 2/1] of a vinyldimethoxymethylsilane (manufactured by Tokyo Chemical Industry Co., Ltd.) were stirred and mixed, 0.074 g (0.17 mmol, 2.0 mol % with respect to 100 mol of the silicone oil containing silanol groups at both ends) of di(2-ethylhexanoate) tin (II) (a concentration of 95 mass %) as a condensation catalyst was added thereto to be stirred at 70°C for two hours. In this way, a first polysiloxane in an oil state was prepared.

After the first polysiloxane was cooled to room temperature, 2.4 g [the molar ratio (vinyl group/hydrosilyl group) of the vinyl group in the vinyltrimethoxysilane to the hydrosilyl group in the organohydrogenpolysiloxane = 1/3] of an organohydrogenpolysiloxane (a polydimethylsiloxane containing hydrosilyl groups at both ends, manufactured by Shin-Etsu Chemical Co., Ltd) as a second polysiloxane and 0.075 mL (15 ppm to the total of the first silicone resin composition) of a solution of trimethyl (methylcyclopentadienyl) platinum (IV) (a platinum concentration of 2 mass %) as an addition catalyst (a hydrosilylation catalyst) were added to the first polysiloxane, so that a transparent first silicone resin composition in an oil state and in an A-stage state was obtained.

### Example 3

A transparent first silicone resin composition in an oil state and in an A-stage state was obtained in the same manner as in Example 2, except that the mixing amount of the organohydrogenpolysiloxane (manufactured by Shin-Etsu Chemical Co., Ltd) was changed from 2.4 g [the molar ratio (vinyl group/hydrosilyl group) of the vinyl group in the vinyltrimethoxysilane to the hydrosilyl group in the organohydrogenpolysiloxane = 1/3] to 0.8 g [the molar ratio (vinyl group/hydrosilyl group) of the vinyl group in the vinyltrimethoxysilane to the hydrosilyl group in the organohydrogenpolysiloxane = 1/1]

### Example 4

A transparent first silicone resin composition in an oil state and in an A-stage state was obtained in the same manner as in Example 2, except that the mixing amount of the solution of trimethyl (methylcyclopentadienyl) platinum (IV) (a platinum concentration of 2 mass %) was changed from 0.075 mL (15 ppm to the total of the first silicone resin composition) to 0.0075 mL (1.5 ppm to the total of the first silicone resin composition).

### Example 5

(Use of Platinum (II) Acetylacetonate as Addition Catalyst)

A transparent first silicone resin composition in an oil state and in an A-stage state was obtained in the same manner as in Example 2, except that 0.075 mL (15 ppm to the total of the first silicone resin composition) of the solution of trimethyl (methylcyclopentadienyl) platinum (IV) (a platinum concentration of 2 mass %) was changed to 0.075 mL (15 ppm to the total of the first silicone resin composition) of the platinum (II) acetylacetonate (2,4-pentanedionato platinum (II), a platinum concentration of 2 mass %).

### Example 6

(Use of Trifunctional Silicon Compound and Bifunctional Silicon Compound in Combination (70:30))

A transparent first silicone resin composition in an oil state and in an A-stage state was obtained in the same manner as in Example 2, except that the mixing amount of the vinyltrimethoxysilane (manufactured by Shin-Etsu Chemical Co., Ltd) was changed from 0.43 g [2.9 mmol, the molar ratio (hydroxyl group/methoxy group) of the hydroxyl group in the silicone oil containing silanol groups at both ends to the methoxy group in the vinyltrimethoxysilane = 2/1] to 0.60 g [4 mmol, the molar ratio (hydroxyl group/methoxy group) of the hydroxyl group in the silicone oil containing silanol groups at both ends to the methoxy group in the vinyltrimethoxysilane = 2/1.4]; the mixing amount of the vinyldimethoxymethylsilane (manufactured by Tokyo Chemical Industry Co., Ltd.) was changed from 0.58 g [4.3 mmol, the molar ratio (hydroxyl group/methoxy group) of the hydroxyl group in the silicone oil containing silanol groups at both ends to the methoxy group in the vinyldimethoxymethylsilane = 2/1] to 0.35 g [2.6 mmol, the molar ratio (hydroxyl group/methoxy group) of the hydroxyl group in the silicone oil containing silanol groups at both ends to the methoxy group in the vinyldimethoxymethylsilane = 2/0.6]; and furthermore, the stirring duration at 70°C was changed to 1.5 hours.

### Example 7

A transparent first silicone resin composition in an oil state was obtained in the same manner as in Example 2, except that the mixing amount of the di(2-ethylhexanoate) tin (II) (a concentration of 95 mass %) as a condensation catalyst was changed from 0.074 g (0.17 mmol, 2.0 mol % with respect to 100 mol of the silicone oil containing silanol groups at both ends) to 0.037 g (0.085 mmol, 1.0 mol % with respect to 100 mol of the silicone oil containing silanol groups at both ends) and the stirring duration at 70°C was changed from 2 hours to 5 hours.

### Comparative Example 1

10 g of A-liquid and 10 g of B-liquid of an addition reaction curable type silicone resin composition in a two-liquid mixed type (manufactured by WACKER ASAHIKASEI CO.,LTD., LR7665) were well mixed, so that a silicone resin composition made of a silicone elastomer was obtained.

### 2. <Fabrication of Encapsulating Sheet Made of Silicone Semi-Cured Material>

An encapsulating sheet made of a silicone semi-cured material was fabricated using each of the silicone resin compositions in Examples 1 to 7 and Comparative Example 1.

To be specific, each of the silicone resin compositions was applied to the surface of a polyester film (manufactured by NIPPA CO., LTD., SS4C, 50 µm) to which fluorine treatment is applied so as to have a thickness of 500 µm to form a film. The film was heated at 135°C for 1 to 10 minutes, so that an encapsulating sheet made of a silicone semi-cured material in a semi-cured state (in a B-stage state) and having a thickness of 500 µm was fabricated.

### 3. <Fabrication of Silicone Cured Material (Completely Cured Material)>

An ultraviolet ray (3 J/cm², a wavelength: 200 to 400 nm) was applied to the encapsulating sheet obtained in 2. <Fabrication of Encapsulating Sheet Made of Silicone Semi-Cured Material> to be thereafter heated at 150°C for 10 minutes, so that a silicone cured material (a completely cured material) in a C-stage state was fabricated.

The properties of 1. <Silicone Resin Composition>, 2. <Encapsulating Sheet>, and 3. <Silicone Cured Material> were evaluated in accordance with the following tests. The results are shown in Table 1.

### Evaluation 1

### (Viscosity)

The viscosity of the silicone resin composition was measured under conditions of 25°C and one pressure using a rheometer.

The temperature of the silicone resin composition was adjusted to be 25°C; the number of revolutions in the measurement was 99 s⁻¹; and an E-type was used as a cone in the rheometer.

### Evaluation 2

### (Duration of Gelation)

The silicone resin composition was added dropwise to a hot plate at 135°C to be heated, so that a duration required for gelation (that is, semi-curing) was measured.

### Evaluation 3

### (Storability)

The hardness of the encapsulating sheet in a B-stage state immediately after fabrication was obtained.

Separately, the hardness of a sheet that was obtained by storing the encapsulating sheet in a B-stage state immediately after fabrication at 25°C for 24 hours was also obtained.

Next, the rate of change of the hardness of sheet (= (the hardness of sheet after storage/the hardness of sheet immediately after preparation) × 100) was calculated as the hardness retention rate (%) and the storage stability was evaluated in accordance with the following evaluation criteria.
[Evaluation Criteria of Storage Stability]
Good: Hardness retention rate is 100 % or more and 150 % or less
Bad: Hardness retention rate is above 150 %

### Evaluation 4

### (Duration Required for Curing (Application of Ultraviolet Ray + Heating))

An ultraviolet ray (3 J/cm²) was applied to the encapsulating sheet to be thereafter heated at 150°C for a predetermined duration described in Table 1.

The tensile elastic modulus (a unit: MPa, a measurement temperature: 25°C) of the encapsulating sheet after each of the heating durations was measured using an autograph (manufactured by Shimadzu Corporation) and the encapsulating sheet at the time when a change in the tensile elastic modulus was not confirmed was defined as a completely cured material (in a C-stage state).

In this way, the heating duration required for curing was obtained.

In the application of the ultraviolet ray, a conveyor UV irradiation device (manufactured by Fusion UV Systems Japan KK., a model number: CY-1100-G) was used.

### Evaluation 5

### (Amount of Irradiation of Ultraviolet Ray Required for Curing)

An ultraviolet ray was applied to the encapsulating sheet in Example 2 at a predetermined amount of irradiation and the tensile elastic modulus (a unit: MPa, a measurement temperature: 25°C) of the encapsulating sheet with each of the amount of irradiation was measured using an autograph (manufactured by Shimadzu Corporation). The encapsulating sheet at the time when a change in the tensile elastic modulus was not confirmed was defined as a completely cured material (in a C-stage state).

In this way, the amount of irradiation of the ultraviolet ray required to be a completely cured material at the same duration as that in Evaluation 4 in Example 2 was obtained.

### Evaluation 6

### (Duration Required for Curing by Heating)

The encapsulating sheet was heated at 150°C for a predetermined duration. The tensile elastic modulus (a unit: MPa, a measurement temperature: 25°C) of the encapsulating sheet with each of the heating durations was measured using an autograph (manufactured by Shimadzu Corporation). The encapsulating sheet at the time when a change in the tensile elastic modulus was not confirmed was defined as a completely cured material. In this way, the heating duration required for curing by heating was obtained.

### Evaluation 7

### (Tensile Elastic Modulus)

The tensile elastic modulus (a unit: MPa, a measurement temperature: 25°C) of the encapsulating sheet was obtained using an autograph (manufactured by Shimadzu Corporation).

### Evaluation 8

### (Light Transmission Properties)

The light transmittance (%) at a wavelength of 450 nm of the silicone cured material immediately after preparation was measured using a spectrophotometer (U-4100, manufactured by Hitachi High-Technologies Corporation).

### Evaluation 9

### (Heat Resistance)

The silicone cured material immediately after preparation was allowed to stand in a warm air dryer at 200°C for 100 hours. Thereafter, the light transmittance (%) of the silicone cured material at a wavelength of 450 nm was measured using a spectrophotometer (U-4100, manufactured by Hitachi High-Technologies Corporation).

**Table 1**

| | | | | Ex. 1 | Ex. 2 | Ex. 3 | Ex. 4 | Ex. 5 | Ex. 6 | Ex. 7 | Comp. Ex. 1 |
|---|---|---|---|---|---|---|---|---|---|---|---|
| Evaluation 1 | Viscosity | | mPa·s | 1760 | 13500 | 14800 | 13500 | 12700 | 30200 | 7900 | 1000 |
| Evaluation 2 | Duration of Gelation at 135°C | | min | 15 | 3 | 4 | 3 | 2 | 2 | 8 | -* |
| Evaluation 3 | Storage Stability | | | Good | Good | Good | Good | Good | Good | Good | - |
| Evaluation 4 | UV (3 J/cm²) + Heating at 150°C | | Heating Duration (min) | 10 | 10 | 10 | 10 | 180 | 10 | 10 | 300 |
| Evaluation 5 | Amount of Irradiation of UV Required for Complete Curing for 10 Minutes | | J/cm² | - | 60 | - | - | - | - | - | - |
| Evaluation 6 | Heating at 150°C Only | | min | 300 | 300 | 300 | 300 | 300 | 300 | 300 | 300 |
| Evaluation 7 | Tensile Elastic Modulus | | MPa | 0.35 | 0.34 | 0.16 | 0.34 | 0.34 | 0.40 | 0.31 | 2.00 |
| Evaluation 8 | Light Transmittance (450 nm) | Immediately After Preparation | (%) | 99.8 | 99.8 | 99.7 | 99.8 | 99.3 | 99.5 | 99.7 | 99.0 |
| Evaluation 9 | | 200°C × 100h | (%) | 99.7 | 99.8 | 99.7 | 99.8 | 99.3 | 99.2 | 99.6 | 98.5 |

| | | | | | | | | | | | |
|---|---|---|---|---|---|---|---|---|---|---|---|
| *Not Turned into Gel | | | | | | | | | | | |

## Claims

1. A silicone resin composition comprising:
a polysiloxane containing at least one pair of condensable substituted groups capable of condensation by heating and at least one pair of addable substituted groups capable of addition by an active energy ray.

2. A silicone resin composition comprising:
a first polysiloxane containing at least one pair of condensable substituted groups capable of condensation by heating and at least one addable substituted group capable of addition by an active energy ray and
a second polysiloxane containing at least one addable substituted group capable of addition by an active energy ray and making one pair with the addable substituted group in the first polysiloxane.

3. The silicone resin composition according to claim 1 or 2, wherein
the one pair of addable substituted groups is at least one combination selected from the group consisting of
combination of a hydrosilyl group and an ethylenically unsaturated group-containing group;
combination of (meth)acryloyl group-containing groups with themselves;
combination of epoxy group-containing groups with themselves; and
combination of a thiol group and an ethylenically unsaturated group-containing group.

4. The silicone resin composition according to claim 1, 2 or 3, wherein
the one pair of condensable substituted groups is at least one combination selected from the group consisting of
combination of at least one substituted group selected from the group consisting of a hydroxyl group, an alkoxy group, an acyloxy group, an amino group, an alkylamino group, an alkenyloxy group, and a halogen atom and a hydroxyl group and
combination of at least one substituted group selected from a hydroxyl group and an alkoxy group and a hydrogen atom.

5. The silicone resin composition according to claim 1, 2, 3 or 4, wherein
the silicone resin composition further contains an addition catalyst and
the addition catalyst is a platinum cyclopentadienyl complex.

6. A semi-cured material sheet obtained by applying and heating a silicone resin composition, wherein
the silicone resin composition comprises a polysiloxane containing at least one pair of condensable substituted groups capable of condensation by heating and at least one pair of addable substituted groups capable of addition by an active energy ray or wherein the silicone resin is as specified in any one of claims 2 to 5.

7. A method for producing a silicone cured material comprising the steps of:
heating a silicone resin composition to obtain a silicone semi-cured material and
applying an active energy ray to the silicone semi-cured material to be cured, wherein
the silicone resin composition comprises a polysiloxane containing at least one pair of condensable substituted groups capable of condensation by heating and at least one pair of addable substituted groups capable of addition by an active energy ray or wherein the silicone resin is as specified in any one of claims 2 to 5.

8. The method for producing a silicone cured material according to claim 7, wherein
in the step of curing the silicone semi-cured material, the silicone semi-cured material is further heated.

9. The method for producing a silicone cured material according to claim 7 or 8, wherein
in the step of obtaining the silicone semi-cured material,
the silicone resin composition is heated at 40 to 180°C for 0.1 to 180 minutes.

10. A method for producing a light emitting diode device comprising:
a step of heating a silicone resin composition to obtain a silicone semi-cured material,
a covering step of covering a light emitting diode element with the silicone resin composition or the silicone semi-cured material, and
an encapsulating step of encapsulating the light emitting diode element by an encapsulating layer made of a silicone cured material formed by applying an active energy ray to the silicone semi-cured material to be cured, wherein
the silicone resin composition contains a polysiloxane containing at least one pair of condensable substituted groups capable of condensation by heating and at least one pair of
addable substituted groups capable of addition by an active energy ray or wherein the silicone resin is as specified in any one of claims 2 to 5.

11. The method for producing a light emitting diode device according to claim 10, wherein
a mounting step in which the light emitting diode element is mounted on a board is further included and
the covering step is performed after the mounting step.

12. The method for producing a light emitting diode device according to claim 10 or 11, wherein
a mounting step in which the light emitting diode element is mounted on a board is further included and
the mounting step is performed after the encapsulating step.

13. A method for producing a light emitting diode device comprising:
an embedding step of embedding a light emitting diode element by a semi-cured material sheet and an encapsulating step of encapsulating the light emitting diode element by an encapsulating layer made of a silicone cured material formed by applying an active energy ray to the semi-cured material sheet to be cured, wherein
the semi-cured material sheet is obtained by applying and heating a silicone resin composition, and
the silicone resin composition comprises a polysiloxane containing at least one pair of condensable substituted groups capable of condensation by heating and at least one pair of addable substituted groups capable of addition by an active energy ray or wherein the silicone resin is as specified in any one of claims 2 to 5.

14. The method for producing a light emitting diode device according to claim 13, wherein
a mounting step in which the light emitting diode element is mounted on a board is further included and
the embedding step is performed after the mounting step.

15. The method for producing a light emitting diode device according to claim 13, wherein
a mounting step in which the light emitting diode element is mounted on a board is further included and
the mounting step is performed after the encapsulating step.

16. A light emitting diode device obtained by a method for producing a light emitting diode device comprising:
a step of heating a silicone resin composition to obtain a silicone semi-cured material,
a covering step of covering a light emitting diode element with the silicone resin composition or the silicone semi-cured material, and
an encapsulating step of encapsulating the light emitting diode element by an encapsulating layer made of a silicone cured material formed by applying an active energy ray to the silicone semi-cured material to be cured, wherein
the silicone resin composition contains a polysiloxane containing at least one pair of condensable substituted groups capable of condensation by heating and at least one pair of addable substituted groups capable of addition by an active energy ray or wherein the silicone resin is as specified in any one of claims 2 to 5.
